# EUROPÄISCHE PATENTSCHRIFT

(11) **EP 1 863 093 B1**
(45) Veröffentlichungstag und Bekanntmachung des Hinweises auf die Patenterteilung: **19.12.2018**
(21) Anmeldenummer: 07009967.6
(22) Anmeldetag: 18.05.2007
(51) Int. Cl.: H01L 27/32, H01L 51/52

(54) **Organisches lichtemittierendes Bauelement, Vorrichtung mit einem organischen lichtemittierenden Bauelement und Beleuchtungseinrichtung sowie Verfahren zur Herstellung eines organischen lichtemittierenden Bauelements**
Organic light-emitting component, device with an organic light-emitting component and illumination device and method for manufacturing an organic light-emitting component
Composant organique émettant de la lumière, dispositif doté d'un composant organique émettant de la lumière et dispositif d'éclairage tout comme procédé destiné à la fabrication d'un composant organique émettant de la lumière

(30) Priorität: 30.05.2006 DE 102006025115; 20.07.2006 DE 102006033713
(43) Veröffentlichungstag der Anmeldung: 05.12.2007
(73) Patentinhaber: OSRAM OLED GmbH, 93049 Regensburg (DE)
(72) Erfinder: Buchhauser, Dirk, 10250 Georgetown, Penang (MY); Gärditz, Christoph, 91052 Erlangen (DE); Heuser, Karsten, Dr., 91056 Erlangen (DE); Sarfert, Wiebke, 91074 Herzogenaurach (DE); Tschamber, Carsten, 22765 Hamburg (DE); Weiss, Oliver, 91054 Erlangen (DE)
(74) Vertreter: Epping - Hermann - Fischer

(56) Entgegenhaltungen:
- EP-A2- 1 296 388
- EP-A2- 1 437 683
- WO-A2-2007/013001
- JP-A- 2000 164 364

## Beschreibung

Organisches lichtemittierendes Bauelement, Vorrichtung mit einem organischen lichtemittierenden Bauelement und Beleuchtungseinrichtung sowie Verfahren zur Herstellung eines organischen lichtemittierenden Bauelements

Die Erfindung betrifft ein organisches lichtemittierendes Bauelement und ein Verfahren zur Herstellung eines solchen.

Organische lichtemittierende Bauelemente weisen in der Regel organische Materialien auf, die sehr leicht Verbindungen mit Wasser und Sauerstoff eingehen können, was in der Regel zu einer beschleunigten Degradation der Bauelemente führt. Um den Kontakt der organischen Materialien mit Wasser und Sauerstoff möglichst weitgehend zu vermeiden, werden organische lichtemittierende Bauelemente üblicherweise verkapselt, wie dies beispielsweise in der Druckschrift WO 01/45140 A2 beschrieben ist.

Zur elektrischen Kontaktierung werden bei herkömmlichen organischen lichtemittierenden Bauelementen elektrische Leiterbahnen durch die Verkapselung nach außen geführt, wo sie an elektrischen Kontaktflächen enden, mit denen das Bauelement an eine Treiberelektronik angeschlossen wird. Im Bereich der durch die Verkapselung geführten Leiterbahnen ist eine zufrieden stellende Dichtigkeit der Verkapselung nur schwer zu erreichen. Die Leiterbahnen wirken als Permeationskanäle und lassen Wasser, Sauerstoff oder andere korrosive Materialien von außen zu den organischen Materialien vordringen.

In der Druckschrift JP 2000-164364 A ist ein organisches, elektrolumineszierendes Bauteil sowie eine Herstellungsmethode hierfür angegeben.

Die Druckschrift EP 1 437 683 A2 betrifft eine IC-Karte und ein Buchungssystem mit einer solchen IC-Karte.

Aus der Druckschrift WO 2007/013001 A2 ist ein lichtemittierendes Bauteil bekannt, das eine Verkapselung und einen integrierten Treiberschaltkreis umfasst.

Es ist eine Aufgabe der vorliegenden Erfindung, ein organisches lichtemittierendes Bauelement anzugeben, bei dem die Gefahr einer Degradation aufgrund von Reaktionen mit Wasser, Luftsauerstoff, oder Ähnlichem verringert ist und das darüber hinaus besonders vielseitig einsetzbar ist. Eine weitere Aufgabe der Erfindung ist es, ein verbessertes Verfahren zur Herstellung eines solchen Bauelements anzugeben.

Diese Aufgaben werden durch ein organisches lichtemittierendes Bauelement gemäß Anspruch 1, eine Vorrichtung gemäß Anspruch 17, eine Beleuchtungseinrichtung gemäß Anspruch 24 und durch ein Verfahren zur Herstellung eines organischen lichtemittierenden Bauelements gemäß Anspruch 26 gelöst.

Vorteilhafte Ausführungsformen und Weiterbildungen sind jeweils in den abhängigen Ansprüchen angegeben. Der Offenbarungsgehalt der Patentansprüche wird hiermit ausdrücklich durch Rückbezug in die Beschreibung aufgenommen.

Ein organisches lichtemittierendes Bauelement gemäß der Erfindung umfasst:
- ein Substrat,
- eine erste Elektrode,
- einen Schichtstapel, der mindestens eine Schicht aufweist, die ein organisches Material enthält und der geeignet ist, im Betrieb elektromagnetische Strahlung zu emittieren,
- eine zweite Elektrode,
- eine Empfängervorrichtung, die geeignet ist, Energie aus einem elektromagnetischen Wechselfeld zu entnehmen und zumindest teilweise in elektrische Energie umzuwandeln und dem Schichtstapel die zur Strahlungsemission benötigte elektrische Energie zur Verfügung zu stellen,
wobei der Schichtstapel und die zweite Elektrode sowie die isolierende Schicht als auch die Empfängervorrichtung zumindest teilweise übereinander angeordnet sind, sodass die Spule zumindest teilweise auf die isolierende Schicht aufgebracht ist, und
wobei auf das Substrat und auf den Schichtstapel eine Verkapselung aufgebracht ist, sodass die Außenfläche des Bauelements frei von elektrischen Kontaktflächen ist.

Das Substrat enthält beispielsweise mindestens eines der folgenden Materialien oder besteht daraus: Glas, Halbleitermaterialien wie Silizium, Metalle wie Stahl oder Edelstahl oder Kunststoffe wie Poly(Ethylenterephthalat) (PET), Poly(butylenterephthalat) (PBT), Poly(ethylennaphthalat) (PEN), Polycarbonat (PC), Polyimid (PI), Polysulfon (PSO), Poly(p-Phenylenethersulfon) (PES), Polyethylen (PE), Polypropylen (PP), Poly(vinylchlorid) (PVC), Polystyrol (PS) oder Poly(methylmetacrylat) (PMMA).

Das Substrat liegt zweckmäßigerweise in Form einer Platte oder einer Folie vor. Beispielsweise ist das Substrat eine Glasplatte, die in einer Ausführungsform eine Dicke von größer oder gleich 0,5 mm und/oder kleiner oder gleich 3 mm hat. Beispielsweise hat die Glasplatte eine Dicke von 1 mm. Bei einer Ausführungsform ist das Substrat sehr dünn und/oder flexibel. Beispielsweise ist ein flexibles Substrat eine dünne Glasplatte mit einer Dicke zwischen 50 und 100 µm, wobei die Grenzen eingeschlossen sind. Bei einer Ausführungsform ist das dünne und/oder flexible Substrat eine Folie, die ein Metall und/oder einen Kunststoff aufweist. Die Folie hat beispielsweise eine Dicke zwischen 50 und 400 um, insbesondere zwischen 100 und 200 um, wobei die Grenzen jeweils eingeschlossen sind. So sind beispielsweise besonders leichte und/oder flexible Bauelemente möglich.

Soll zumindest ein Teil der von dem Schichtstapel im Betrieb erzeugten Strahlung durch das Substrat hindurch ausgekoppelt werden, weist dieses zweckmäßigerweise ein Material auf, das für eine von dem Schichtstapel emittierte Strahlung zumindest teilweise durchlässig ist.

Die erste Elektrode ist auf dem Substrat aufgebracht. Es kann sich dabei entweder um die Anode oder um die Kathode handeln. Handelt es sich bei der ersten Elektrode um die Anode, weist diese zweckmäßigerweise ein Material auf, das eine hohe Austrittsarbeit für Elektronen, bevorzugt von größer oder gleich 4,5 eV, besitzt. In der Anode ist beispielsweise ein Metall wie Pt, Au, In und/oder Pd, ein transparentes, leitfähiges Oxid, insbesondere Indium-Zinn-Oxid (ITO), Bleioxid und/oder Zinnoxid, LiF und/oder Graphit, ein anorganisches Halbleitermaterial wie Si, Ge bzw. GaAs und/oder ein leitfähiges Polymer wie Polypyrrol, Polyanilin (PANI) und/oder Poly-3,4-ethylendioxythiophen (PEDOT) enthalten.

Stellt die erste Elektrode eine Kathode dar, weist sie üblicherweise ein Material mit einer niedrigen Austrittsarbeit für Elektronen auf. Beispielsweise enthält die Kathode Ca, Mg, eine Magnesiumlegierung wie Mg:Ag, Yb, Ba, eine Aluminiumlegierung wie Li:Al oder eine Kombination aus mindestens zwei dieser Materialien.

Dicke und/oder Material der ersten Elektrode werden gemäß einer Ausführungsform so gewählt, dass eine von dem Schichtstapel im Betrieb emittierte Strahlung zumindest teilweise durch die erste Elektrode ausgekoppelt wird. Als Materialien sind hierfür im Fall einer ersten Elektrode, die eine Anode ist, beispielsweise transparente leitfähige Oxide geeignet, die in der Regel zumindest teilweise für eine von dem Schichtstapel im Betrieb emittierte Strahlung durchlässig sind.

Alternativ kann die von dem Schichtstapel im Betrieb erzeugte elektromagnetische Strahlung durch die zweite Elektrode ausgekoppelt werden, die auf der der ersten Elektrode gegenüberliegenden Seite des Schichtstapels aufgebracht ist. Dann umfasst die erste Elektrode bevorzugt zusätzlich eine metallische Schicht mit guten Reflexionseigenschaften für die von dem Schichtstapel emittierte Strahlung. Beispielsweise enthält die metallische Schicht Ag, Al, Mg, Ca, Pt und/oder eine Legierung, die mindestens zwei dieser Metalle umfasst.

Bei der zweiten Elektrode kann es sich entweder um die Kathode oder um die Anode handeln. Stellt die erste Elektrode eine Anode dar, handelt es sich bei der zweiten Elektrode um eine Kathode und umgekehrt. Geeignete Materialien entsprechen den für die erste Elektrode beschriebenen. Bevorzugt umfasst die Kathode eine erste Schicht, die mindestens ein Alkalimetall und/oder ein Erdalkalimetall aufweist. Besonders bevorzugt umfasst sie auch eine zweite Schicht, die ein Metall, beispielsweise Al, Ag und/oder Au, aufweist.

Der Schichtstapel ist auf der ersten Elektrode aufgebracht. Er umfasst mindestens eine Schicht, die mindestens ein organisches Material aufweist. Dabei handelt es sich z. B. um ein niedermolekulares Material ("small molecules") und/oder ein Polymer.

Der Schichtstapel umfasst eine im Betrieb lichtemittierende Schicht, die ein Emittermaterial, insbesondere ein organisches Emittermaterial, enthält. Zu geeigneten Emittermaterialien zählen beispielsweise photo- und/oder elektrolumineszierende, fluoreszierende und phosphoreszierende organische Materialien mit niedrigem oder hohem Molekulargewicht.

Geeignete Materialien mit niedrigem Molekulargewicht (niedermolekulare Materialien) sind beispielsweise Tris-8-aluminium-quinolinol-Komplexe wie Tris-(8-hydroxy-chinolinato)-aluminium (Alq₃), 1,4-bis(2,2-diphenylvinyl)biphenyl (DPVBi) und Cumarine.

Geeignete organische Materialien mit hohem Molekulargewicht sind zum Beispiel organische oder organometallische Polymere. Dazu gehören Polyfluorene, Polythiophene, Polyphenylene, Polythiophenvinylene, Poly-p-Phenylenvinylene (PPV), Polyspiro Polymere und ihre Familien, Kopolymere, Derivate und Mischungen.

Bei einer Ausführungsform umfasst der Schichtstapel auch eine, vorzugsweise der Anode benachbarte, Lochtransportschicht und/oder eine, vorzugsweise der Kathode benachbarte, Elektronentransportschicht. Solche Loch- bzw. Elektronentransportschichten sind beispielsweise in der Druckschrift US 2005/0158523 A1 beschrieben. Die Lochtransportschicht weist zum Beispiel PEDOT, 4,4',4"-Tris(N-(1-naphthyl)-N-phenyl-amino)-triphenylamine (1-Naphdata) und/oder 4,4'-bis[N-(1-naphtyl)-N-phenyl-amino]biphenyl (α-NPD) auf oder besteht aus mindestens einem dieser Materialien. Die Elektronentransportschicht weist beispielsweise 4,7-Diphenyl-1,10-phenantroline (BPhen) und/oder Alq₃ auf oder besteht daraus.

Das organische lichtemittierende Bauelement wird zum Betrieb einem elektromagnetischen Wechselfeld ausgesetzt. Bei dem elektromagnetischen Wechselfeld handelt es sich um ein elektrisches und/oder magnetisches Feld, das zeitlich variiert. Die zeitliche Variation erfolgt besonders bevorzugt periodisch. Beispielsweise handelt es sich bei dem elektromagnetischen Wechselfeld um ein Hochfrequenzfeld oder um Mikrowellen. Bei einer Ausführungsform hat das elektromagnetische Wechselfeld eine Frequenz zwischen 30 und 500 kHz, bei einer anderen Ausführungsform eine Frequenz zwischen 10 und 15 MHz, wobei die Grenzen jeweils eingeschlossen sind.

Es entnimmt die Empfängervorrichtung diesem elektromagnetischen Wechselfeld Energie. Die Empfängervorrichtung ist dazu geeignet, diese zumindest teilweise in elektrische Energie umzuwandeln und einen Strom in den Schichtstapel einzuprägen. So stellt die Empfängervorrichtung im Betrieb dem Schichtstapel die zur Strahlungsemission benötigte elektrische Energie zur Verfügung. Dazu ist die Empfängervorrichtung vorzugsweise mit der ersten und der zweiten Elektrode elektrisch leitend verbunden.

Es umfasst die Empfängervorrichtung eine Spule, bevorzugt eine Mikrospule, auch als Antenne bezeichnet, die dazu vorgesehen ist, dem elektromagnetischen Wechselfeld Energie zu entnehmen. Es induziert ein elektromagnetisches Wechselfeld in der Spule eine Spannung, die in dem durch den Schichtstapel und ggf. weitere elektrische und/oder elektronische Bauteile geschlossenen Stromkreis einen Strom durch den Schichtstapel hervorruft. Eine Mikrospule hat beispielsweise im Querschnitt eine Höhe von kleiner oder gleich 2 mm, bevorzugt von kleiner oder gleich 1 mm und/oder eine Breite von kleiner oder gleich 5 mm, bevorzugt von kleiner oder gleich 3 mm. Die Länge einer Mikrospule beträgt bei einer Ausführungsform zwischen 20 mm und 50 mm, wobei die Grenzen eingeschlossen sind, beispielsweise beträgt sie 30 mm. Bei mindestens einer Ausführungsform hat die Mikrospule einen Ferritkern.

Eine Vorrichtung, welche die dem elektromagnetischen Wechselfeld von der Empfängervorrichtung entnommene Energie über einen längeren Zeitraum - also für eine längere Dauer als eine oder wenige Perioden des elektromagnetischen Wechselfeldes - speichert oder akkumuliert (wie beispielsweise ein Akkumulator), ist für den Betrieb des Bauelements nicht notwendig. Vielmehr wird mit der dem elektromagnetischen Wechselfeld entnommenen Energie der Schichtstapel bevorzugt praktisch zeitgleich mit Strom versorgt.

Die Spule bzw. Antenne ist beispielsweise auf dem Substrat angeordnet, insbesondere ragt die Spule bzw. Antenne in Draufsicht auf die Haupterstreckungsebene des Substrats nicht über dieses hinaus.

Es ist auf die zweite Elektrode eine isolierende Schicht aufgebracht, die die zweite Elektrode zumindest teilweise bedeckt. Die Antenne ist zumindest teilweise auf der isolierenden Schicht angeordnet. Beispielsweise umfasst die Antenne eine Leiterbahn oder mehrere Leiterbahnen, die bevorzugt auf die isolierende Schicht aufgedampft ist bzw. sind. Besonders bevorzugt erstreckt sich die Leiterbahn auch auf die erste und/oder zweite Elektrode.

Die Antenne bzw. Spule hat beispielsweise die Form einer Spirale, zum Beispiel einer dreieckigen, rechteckigen, sechseckigen oder achteckigen Spirale. Bei einer drei-, sechs- bzw. achteckigen Spirale hat eine Windung der Spirale drei, sechs bzw. acht Ecken. Die Ecken einer oder mehrerer Windungen der Spirale sind bei einer Ausführungsform abgerundet. Auch andere Geometrien sind für die Antenne denkbar.

Die Antenne weist in der Regel zwei Enden auf, von denen beispielsweise ein erstes Ende mit der ersten Elektrode verbunden ist und ein zweites Ende mit der zweiten Elektrode verbunden ist. Alternativ kann zwischen dem ersten Ende der Antenne und der ersten Elektrode und/oder zwischen dem zweiten Ende der Antenne und der zweiten Elektrode mindestens ein weiteres, elektrisches oder elektronisches Bauteil der Empfängervorrichtung angeordnet sein. Dabei kann es sich beispielsweise um einen Widerstand, eine Diode, einen Kondensator, eine Spule und/oder eine Schaltung aus mehreren Bauteilen handeln.

Bei einer zweckmäßigen Ausführungsform bedeckt die isolierende Schicht einen Randbereich der zweiten Elektrode und lässt einen mittleren Bereich der zweiten Elektrode frei. Beispielsweise ist dann das zweite Ende der Antenne auf dem mittleren Bereich der zweiten Elektrode aufgebracht und mit diesem elektrisch leitend verbunden. Bei einer Variante dieser Ausführungsform bleibt ein Randbereich der zweiten Elektrode von der isolierenden Schicht unbedeckt, auf dem insbesondere das zweite Ende der Antenne angeordnet und mit der zweiten Elektrode elektrisch leitend verbunden ist.

Die isolierende Schicht weist zum Beispiel Al₂O₃, Polytetrafluorethylen, Polystyrol (PS) und/oder Poly(methylmetacrylat) (PMMA) auf oder besteht aus einem dieser Materialien.

Alternativ kann es sich bei der isolierenden Schicht auch um eine selbstorganisierte Monolage handeln. Eine selbstorganisierte Monolage weist vorzugsweise molekulare Gruppen auf, insbesondere besteht sie aus einer Monolage molekularer Gruppen. Eine molekulare Gruppe umfasst zum Beispiel eine Ankergruppe, die geeignet ist, sich an der zweiten Elektrode anzulagern. Bevorzugt umfasst die molekulare Gruppe auch eine dielektrische Einheit, die der Ankergruppe an der von der zweiten Elektrode entfernten Seite nachgeordnet ist. Solche selbstorganisierten Monolagen und molekularen Gruppen sind beispielsweise in den Druckschriften DE 103 28 811 A1, DE 10 2004 005 082 A1 und DE 10 2004 057 760 A1 beschrieben. Eine isolierende Schicht, die eine selbstorganisierte Monolage aus molekularen Gruppen ist, ist besonders einfach herstellbar und weist keine oder nur wenige Fehlstellen auf, an denen die zweite Elektrode nicht bedeckt ist. Sie hat zudem vorteilhafterweise einen besonders hohen elektrischen Widerstand.

Es erfolgt das Auskoppeln der von dem Schichtstapel im Betrieb erzeugten Strahlung bei einer Ausführungsform im Wesentlichen durch die erste Elektrode und das Substrat hindurch ("bottom-emitter").

Bei einer weiteren Ausführungsform wird die von dem Schichtstapel im Betrieb erzeugte elektromagnetische Strahlung zumindest teilweise durch die zweite Elektrode hindurch ausgekoppelt ("top-emitter").

Beispielsweise umfasst die Antenne dazu ein Material, das für die von dem Schichtstapel emittierte elektromagnetische Strahlung zumindest teilweise durchlässig ist, insbesondere ein transparentes, leitfähiges Oxid (Transparent Conducting Oxide, TCO) wie Indium-Zinn-Oxid (ITO) und/oder eine dünne Metallschicht. In diesem Fall wird zumindest ein Teil der elektromagnetischen Strahlung durch die Antenne hindurch ausgekoppelt.

Alternativ kann von dem Schichtstapel im Betrieb emittierte Strahlung auch durch eine erste und/oder zweite Elektrode hindurch ausgekoppelt werden, auf der eine Antenne angeordnet ist, die im Wesentlichen nicht transparent ist. In diesem Fall wird die Strahlung praktisch nur durch die von der Antenne nicht bedeckten Stellen ausgekoppelt, beispielsweise wenn die Antenne in Draufsicht auf die Haupterstreckungsebene des Schichtstapels nur einen geringen Teil, insbesondere einen Randbereich, der Fläche des strahlungsemittierenden Schichtstapels überdeckt.

Bei einer Ausführungsform ist die Empfängervorrichtung geeignet, Wechselstrom gleichzurichten. Dazu umfasst die Empfängervorrichtung beispielsweise mindestens eine Diode. Beispielsweise umfasst die Empfängervorrichtung eine Diode, die in Reihe mit der Spule oder Antenne und dem Schichtstapel geschaltet ist. Bei einer anderen Ausführungsform umfasst die Empfängervorrichtung eine Gleichrichterbrücke, die bei einer Ausführungsform eine Graetz-Schaltung mit vier Dioden ist.

Bei einer weiteren Ausführungsform umfasst die Empfängervorrichtung wenigstens einen Kondensator, der beispielsweise dazu dient, die Spannung bzw. den Strom zu glätten. Vorteilhafterweise wird so ein möglichst konstanter Gleichstrom in den Schichtstapel eingeprägt und eine möglichst gleichmäßige Emission des Bauelements erzielt. Bei einer Ausführungsform umfasst die Empfängervorrichtung einen Schwingkreis, der zumindest die Antenne und/oder Spule und einen Kondensator umfasst. Bevorzugt ist die Resonanzfrequenz des Schwingkreises auf die Frequenz des elektromagnetischen Wechselfelds abgestimmt. So wird mit Vorteil eine besonders effiziente Entnahme von Energie aus dem elektromagnetischen Wechselfeld erzielt.

Die Diode, der Kondensator und/oder gegebenenfalls weitere, in der Empfängervorrichtung enthaltene, elektronische Bauteile sind zweckmäßigerweise miniaturisiert ausgeführt.

Alternativ kann eine Schichtstruktur auf dem Substrat angeordnet sein, welche die Diode, den Kondensator und/oder weitere elektronische Bauteile darstellt. Die Schichtstruktur umfasst beispielsweise mindestens eine organische Halbleiterschicht, eine anorganische Halbleiterschicht und/oder eine Metallschicht. Insbesondere ist die Schichtstruktur aufgedampft oder mittels Molekularstrahlepitaxie (MBE) aufgebracht. Die organische und/oder die anorganische Halbleiterschicht und/oder die Metallschicht ist (sind) insbesondere strukturiert, zum Beispiel mittels Photolithographie. Beispielsweise bilden sie einen integrierten Schaltkreis. So ist eine besonders geringe Baugröße des organischen lichtemittierenden Bauelements möglich.

Die Diode, der Kondensator und/oder ggf. weitere elektronische Bauteile sind beispielsweise auf dem Substrat, zum Beispiel neben und/oder über dem Schichtstapel angeordnet. Beispielsweise ist die Schichtstruktur zwischen der ersten Elektrode und dem Substrat oder auf einem von dem Schichtstapel unbedeckten Bereich des Substrats, also seitlich neben dem Schichtstapel, angeordnet. Alternativ kann die Schichtstruktur auch nachfolgend auf die von dem Substrat entfernte Seite des organischen Schichtstapels angeordnet sein.

Es weist das organische lichtemittierende Bauelement eine Verkapselung auf. Die Verkapselung ist derart auf dem Substrat angeordnet, dass sie zusammen mit diesem den Schichtstapel umschließt. Mit anderen Worten umschließen das Substrat und die Verkapselung einen Innenraum, in dem der Schichtstapel angeordnet ist, vollständig. So wird ein Kontakt des Schichtstapels, insbesondere des in dem Schichtstapel enthaltenen organischen Materials, mit korrosiven Stoffen wie Wasser oder Sauerstoff vermieden.

Beispielsweise handelt es sich bei der Verkapselung um eine Kappe, die bevorzugt Glas, eine Keramik oder einen Kunststoff aufweist oder aus mindestens einem dieser Materialien besteht. Bei einer Ausführungsform umfasst die Kappe beispielsweise einen Farbfilter und/oder ein Fluoreszenzkonversionsmaterial. Bei einer weiteren Ausführungsform hat sie keinen direkten Kontakt zu dem Schichtstapel. Zu diesem Zweck können beispielsweise Abstandshalterteilchen und/oder Stützpfosten vorgesehen sein, wie sie beispielsweise in den Druckschriften WO 01/45140 und WO 01/44865 beschrieben sind. Bei einer Ausführungsform ist auf die dem Schichtstapel zugewandte Seite der Kappe ein Gettermaterial, beispielsweise Barium, aufgebracht. Das Gettermaterial ist insbesondere dazu geeignet, Gase, die den Schichtstapel schädigen können, chemisch oder physikalisch zu binden. Solche Gettermaterialien sind beispielsweise in den Druckschriften US 2004/0051449 und US 2004/0048033 beschrieben.

Mittels eines zwischen dem Substrat und einem Randbereich der Kappe angeordneten Klebstoffs ist die Kappe zweckmäßigerweise mechanisch stabil mit dem Substrat verbunden. Vorzugsweise ist der Klebstoff im Wesentlichen undurchlässig für Wasser und Sauerstoff bzw. weitere oxidierende Stoffe. Beispielsweise wird ein Klebstoff auf Basis von Epoxidharz oder Lötglas verwendet.

Bei einer alternativen Ausführungsform ist das organische lichtemittierende Bauelement mit mindestens einer polymeren und einer anorganischen Schicht verkapselt, bevorzugt mit einer, insbesondere alternierenden, Folge mehrerer solcher Schichten. Beispielsweise umfasst eine solche Folge von polymeren und anorganischen Schichten mindestens eine aktive polymere Schicht, die bevorzugt dazu geeignet ist, Feuchtigkeit und/oder oxidierende Stoffe zu binden, und mindestens eine keramische Schicht. Eine solche Schichtenfolge ist beispielsweise in der Druckschrift WO 2004/107468, offenbart. Bei zumindest einer Ausführungsform ist eine solche Verkapselung sehr dünn und/oder flexibel. Mit Vorteil wird mit einer solchen Dünnschichtverkapselung ein Bauelement mit einer besonders geringen Bauhöhe erzielt. Zudem ist vorteilhafterweise die Herstellung eines flexiblen Bauelements möglich.

Bei einer bevorzugten Ausführungsform überdeckt die Verkapselung das Substrat in Draufsicht auf das Substrat vollständig. Besonders bevorzugt sind das Substrat und die Verkapselung in Draufsicht auf das Substrat bündig zueinander angeordnet. Das heißt, das Substrat und die Verkapselung haben in Draufsicht auf die Haupterstreckungsebene die gleiche Ausdehnung und sind deckungsgleich. Alternativ zu der bündigen Anordnung kann die Verkapselung in Draufsicht auf das Substrat auch über den Rand des Substrats hinausragen. Bevorzugt ist ein Teil der Verkapselung in diesem Fall in der Haupterstreckungsebene des Substrats seitlich neben diesem angeordnet und bedeckt eine nicht parallel zur Haupterstreckungsebene verlaufende, insbesondere umlaufende, Seitenfläche des Substrats stellenweise oder vollständig. Besonders bevorzugt ist die Verkapselung mit einem Klebstoff mit der Seitenfläche des Substrats verklebt. Beispielsweise weist die Verkapselung eine, insbesondere umlaufende, Stufe zur Aufnahme des Substrats auf. Vorzugsweise ist im Bereich der Stufe die dem Schichtstapel zugewandte Seite und die Seitenfläche des Substrats mit der Verkapselung mittels eines Klebstoffs verbunden.

Es weist die Außenfläche des verkapselten Bauelements keine elektrischen Kontaktflächen auf. Die Außenfläche ist dabei der vom Innenraum abgewandte Teil der Oberfläche des Bauelements, insbesondere die von dem Schichtstapel abgewandten Flächen des Substrats und der Verkapselung. Mit anderen Worten sind keine elektrischen Anschlüsse und/oder Leiterbahnen von dem durch die Verkapselung und das Substrat eingeschlossenen Innenraum, der den Schichtstapel umfasst, in den Außenraum geführt.

Vorteilhafterweise weist ein solches Bauelement keine elektrischen Durchführungen zwischen dem Innenraum und dem Außenraum auf. Solche elektrischen Durchführungen können beispielsweise Diffusionskanäle darstellen, die ein Eindringen von Wasser und/oder Sauerstoff bzw. anderen oxidierenden Stoffen in den Innenraum erleichtern und so die Alterung des Bauelements beschleunigen. Bei einem organischen lichtemittierenden Bauelement ohne äußere elektrische Kontaktflächen ist zudem vorteilhafterweise eine im Verhältnis zur Grundfläche des Substrats besonders große aktive Fläche möglich, da beispielsweise kein Teilbereich des Substrats zur Ausbildung von äußeren elektrischen Kontaktflächen frei von dem Schichtstapel bleiben muss.

Bei einer zweckmäßigen Ausführungsform ist die Empfängervorrichtung dazu vorgesehen, ein elektromagnetisches Wechselfeld einer vorbestimmten Wellenlänge oder eines vorbestimmten Wellenlängenbereichs zu detektieren. Das organische lichtemittierende Bauelement wird dann beispielsweise als optischer Hochfrequenzsensor verwendet. Zweckmäßigerweise prägt die Empfängervorrichtung genau dann einen Strom in den Schichtstapel ein, sodass dieser elektromagnetische Strahlung, bevorzugt im sichtbaren Spektralbereich, emittiert, wenn sie ein elektromagnetisches Feld der vorbestimmten Wellenlänge oder des vorbestimmten Wellenlängenbereichs empfängt. Bei einer Ausführungsform umfasst die Empfängervorrichtung eine Spule oder Antenne, deren Länge auf die vorbestimmte Wellenlänge bzw. den vorbestimmten Wellenlängenbereich abgestimmt ist. Bevorzugt beträgt die Länge einer solchen Antenne ein ganzzahliges Vielfaches eines Viertels, besonders bevorzugt der Hälfte, der vorbestimmten Wellenlänge bzw. einer Wellenlänge, insbesondere einer mittleren Wellenlänge, des vorbestimmten Wellenlängenbereichs.

Ein solches organisches lichtemittierendes Bauelement ist beispielsweise mit Vorteil als Anzeige-Element für den Betriebszustand einer Hochfrequenzanlage, beispielsweise einer Sendeanlage, etwa für Funk, geeignet. Beispielsweise ist das Bauelement dazu als Plakette ausgeführt, die zum Beispiel an der Kleidung befestigt wird. Ein solches Anzeige-Element ist beispielsweise mit Vorteil dazu geeignet, Wartungspersonal mit einem optischen Signal zu warnen, das sich im bestrahlten Bereich einer nicht abgeschalteten Sendeanlage aufhält.

Bei einer weiteren Ausführungsform umfasst das organische lichtemittierende Bauelement ein datenspeicherndes Bauelement, das zur Speicherung von Informationen geeignet ist.

Bei einer Ausführungsform ist das datenspeichernde Bauelement dazu geeignet, ein Bit an Information zu speichern. Beispielsweise kann das datenspeichernde Bauelement intakt oder zerstört sein. Der Zustand ("intakt" bzw. "zerstört") des datenspeichernden Bauelements entspricht dann jeweils einem Zustand ("1" bzw. "0") des darzustellenden Bits. Ein organisches lichtemittierendes Bauelement mit einem solchen datenspeichernden Bauelement ist besonders gut als Sicherungs-Etikett, etwa zur Sicherung von Waren, geeignet. Beispielsweise ist das datenspeichernde Bauelement in diesem Fall ein Kondensator, etwa ein Folienkondensator, der insbesondere eine Soll-Kurzschlussstelle aufweist.

Bei einer anderen Ausführungsform ist das datenspeichernde Bauelement ein Halbleiterbauelement und umfasst insbesondere einen integrierten Schaltkreis. Beispielsweise handelt es sich bei dem Halbleiterbauelement um einen RFID(Radio Frequency Identification)-Chip.

Ein organisches lichtemittierendes Bauelement mit einem datenspeichernden Bauelement ist dazu geeignet, elektromagnetische Strahlung - bevorzugt im sichtbaren Spektralbereich - zu emittieren, wenn Informationen von oder zu dem datenspeichernden Bauelement übertragen werden. Beispielsweise kann so mit Vorteil ein Schreib- und/oder Lesevorgang auf einem RFID-Chip oder die Deaktivierung eines Sicherungs-Etiketts angezeigt werden.

Eine Vorrichtung gemäß der Erfindung umfasst mindestens ein organisches lichtemittierendes Bauelement und eine Steuereinheit, welche die Empfängervorrichtung des Bauelements im Betrieb mit elektrischer Energie versorgt. Die Steuereinheit ist dabei insbesondere galvanisch von dem organischen lichtemittierenden Bauelement getrennt, es gibt also keine elektrisch leitende Verbindung zwischen dem Bauelement, insbesondere der Empfängervorrichtung, und der Steuereinheit.

Die Trennung des Bauelements von der Steuereinheit erlaubt es vorteilhafterweise, das Bauelement oder die Steuereinheit der Vorrichtung, beispielsweise im Defektfall, einzeln auszutauschen. Auch ein Auswechseln des Bauelements durch ein anderes erfindungsgemäßes organisches lichtemittierendes Bauelement, das beispielsweise elektromagnetische Strahlung mit einer anderen Spektralverteilung emittiert, ist in einfacher Weise möglich.

Ein elektrisches Kontaktieren des Bauelements mittels Drähten oder Kabeln an elektrischen Kontaktflächen ist dabei im Gegensatz zu Bauelementen herkömmlicher Bauart vorteilhafterweise nicht nötig. Solche Kontaktflächen sind als dünne Metallschichten anfällig für mechanische Beschädigungen und Korrosion. Abnutzungserscheinungen und Fehlfunktionen, die bei Bauelementen herkömmlicher Bauart - insbesondere bei häufigem Kontaktieren - als Folge auftreten, werden so mit Vorteil vermieden.

Bei einer bevorzugten Ausführungsform ist die Steuereinheit dazu vorgesehen, im Betrieb aus einem Wechselstrom und/oder aus einem zeitlich variierenden Gleichstrom ein elektromagnetisches Wechselfeld zu erzeugen. Dazu wird beispielsweise über eine Spule und/oder eine Antenne ein zeitlich variierendes Magnetfeld und/oder elektrisches Feld erzeugt und aus der Steuereinheit ausgekoppelt. Der Wechselstrom bzw. der zeitlich variierende Gleichstrom hat beispielsweise ein sinusförmiges, rechteckförmiges oder dreieckförmiges Profil. Das von der Steuereinheit erzeugte elektromagnetische Wechselfeld ist vorzugsweise induktiv in die Empfängervorrichtung des organischen lichtemittierenden Bauelements eingekoppelt. Auch eine kapazitive Einkopplung ist denkbar. Besonders bevorzugt ist die Frequenz und/oder die Intensität des elektromagnetischen Wechselfelds auf die Empfängervorrichtung abgestimmt. So wird eine besonders effiziente Einkopplung erzielt.

Ein organisches lichtemittierendes Bauelement mit einem datenspeichernden Bauelement, das zur Speicherung von Informationen geeignet ist, beispielsweise mit einem RFID-Chip, wird bevorzugt von einer Steuereinheit mit elektrischer Energie versorgt, die zusätzlich dazu geeignet ist, Informationen an das datenspeichernde Bauelement zu übertragen und/oder von diesem zu empfangen. Besonders bevorzugt dient das von der Steuereinheit erzeugte elektromagnetische Wechselfeld sowohl zur Übertragung der Energie als auch der Informationen. Beispielsweise kann die Frequenz, die Phase und/oder die Amplitude des elektromagnetischen Wechselfelds moduliert werden, um die Informationen zu übertragen. Bei einem organischen lichtemittierenden Bauelement, das ein Sicherungs-Etikett darstellt, ist eine bevorzugte Steuereinheit ein Deaktivator, der ein elektromagnetisches Wechselfeld erzeugt, das insbesondere dazu geeignet ist, das datenspeichernde Bauelement zu zerstören.

Die Empfängervorrichtung ist vorzugsweise dazu vorgesehen, die übertragenen Informationen zu empfangen - beispielsweise mittels Demodulation des elektromagnetischen Wechselfelds - und an das datenspeichernde Bauelement zu übertragen. Bei zumindest einer Ausführungsform ist die Empfängervorrichtung alternativ oder zusätzlich dazu vorgesehen, Informationen von dem datenspeichernden Bauelement an die Steuereinheit zu senden.

Beispielsweise bei der Übertragung von Informationen von dem datenspeichernden Bauelement zu der Steuereinheit wird bei einer Ausführungsform eine als Lastmodulation bezeichnete Variante der Amplitudenmodulation verwendet. Bei der Lastmodulation unterscheidet sich der Betrag der elektrischen Energie, der zu verschiedenen Zeiten beispielsweise von der Empfängervorrichtung aus dem elektromagnetischen Wechselfeld aufgenommen wird. Dies wird zum Beispiel durch Ein- und Ausschalten eines Modulationswiderstands der Empfängervorrichtung erreicht. Die unterschiedliche Energieentnahme aus dem elektromagnetischen Wechselfeld wird in diesem Fall zweckmäßigerweise von der Steuereinheit detektiert.

Die Frequenz des von der Steuereinheit erzeugten elektromagnetischen Wechselfeldes beträgt beispielsweise zwischen 30 und 500 kHz oder zwischen 10 und 15 MHz, wobei die Grenzen jeweils eingeschlossen sind. Diese Frequenzbereiche sind besonders vorteilhaft, wenn das organische lichtemittierende Bauelement ein zur Speicherung von Informationen geeignetes Halbleiterbauelement enthält.

Bei einer weiteren Ausführungsform ist das organische lichtemittierende Bauelement in oder an einer Halterung angeordnet. Bevorzugt enthält die Halterung die Steuereinheit. Beispielsweise kann die Halterung einen Innenraum aufweisen, in dem die Steuereinheit angeordnet ist, oder eine Außenfläche der Halterung und eine Außenfläche der Steuereinheit können mechanisch stabil, insbesondere unlösbar, miteinander verbunden sein.

Zweckmäßigerweise ist das Bauelement mechanisch stabil mit der Halterung verbunden. So wird vorteilhafterweise eine definierte Anordnung der Empfängervorrichtung zu der Steuereinheit erzielt, sodass beispielsweise das elektromagnetische Wechselfeld besonders effizient in die Empfängervorrichtung eingekoppelt werden kann. Die Verbindung kann dabei entweder reversibel - anders ausgedrückt einfach lösbar - oder irreversibel ausgeführt sein. Beispielsweise weist das Bauelement mindestens ein Haltemittel auf, das bevorzugt zur Verbindung mit mindestens einem Stützmittel der Halterung vorgesehen ist. Besonders bevorzugt ist die Verbindung von Haltemittel und Stützmittel einfach lösbar, beispielsweise indem das Stützmittel und/oder das Haltemittel federnd gelagert und/oder flexibel ausgeführt sind.

Bei einer weiteren Ausführungsform ist die Steuereinheit ein Hochfrequenzgerät. Beispielsweise handelt es sich bei dem Hochfrequenzgerät um eine Mikrowellenanlage. Ein solches Hochfrequenzgerät ist üblicherweise dazu vorgesehen, Gegenstände mit dem erzeugten elektromagnetischen Wechselfeld zu bestrahlen. Das organische lichtemittierende Bauelement ist zweckmäßigerweise so in dem von dem elektromagnetischen Wechselfeld bestrahlten Gebiet angeordnet, dass es von dem elektromagnetischen Wechselfeld mit Energie versorgt wird.

Zum Beispiel weist das Hochfrequenzgerät einen Innenraum auf, in den im Betrieb Gegenstände eingebracht und mit dem von dem Hochfrequenzgerät erzeugten Wechselfeld bestrahlt werden. Das organische lichtemittierende Bauelement befindet sich bevorzugt in diesem Innenraum oder grenzt an diesen an, sodass es von dem erzeugten elektromagnetischen Wechselfeld mit Energie versorgt wird.

Das organische lichtemittierende Bauelement ist vorteilhafterweise dazu geeignet, den Betriebszustand des Hochfrequenzgeräts anzuzeigen. Das Bauelement emittiert in der Regel genau dann elektromagnetische Strahlung, wenn das Hochfrequenzgerät ein elektromagnetisches Wechselfeld erzeugt. Die Intensität der von dem organischen lichtemittierenden Bauelement emittierten Strahlung ist bei einer Ausführungsform abhängig von der Intensität des elektromagnetischen Wechselfelds.

Mit anderen Worten wird das Bauelement als optische Kontrollanzeige für ein solches Hochfrequenzgerät verwendet.

Bei einer Variante dieser Ausführungsform wird eine Mehrzahl von organischen lichtemittierenden Bauelementen von einem solchen Hochfrequenzgerät als Steuereinheit mit Energie versorgt. Die Empfängereinheit mindestens eines Bauelements ist dabei so ausgeführt, dass das organische lichtemittierende Bauelement nur elektromagnetische Strahlung emittiert, wenn das von der Steuereinheit erzeugte elektromagnetische Wechselfeld eine definierte, minimale Intensität überschreitet. Bevorzugt sind die Empfängereinheiten einer Mehrzahl von Bauelementen so ausgeführt, dass sie bei unterschiedlichen, minimalen Intensitäten des von der Steuereinheit erzeugten elektromagnetischen Wechselfelds zu einer Emission von elektromagnetischer Strahlung der organischen lichtemittierenden Bauelemente führen. Beispielsweise haben die Spulen bzw. Antennen der Empfängervorrichtungen unterschiedliche Geometrien und/oder unterschiedliche Anzahlen von Windungen. Bei dieser Ausführungsform kann vorteilhafterweise aus dem durch den Betriebszustand der Bauelemente gebildeten Muster auf die Intensität der von der Steuereinheit erzeugten elektromagnetischen Strahlung geschlossen werden.

Ein weiterer Aspekt der Erfindung betrifft eine Beleuchtungseinrichtung, die mindestens ein erfindungsgemäßes organisches lichtemittierendes Bauelement umfasst. Eine solche Beleuchtungseinrichtung braucht in der Umgebung der lichtemittierenden Fläche vorteilhafterweise keine elektrischen Zuleitungen aufzuweisen. Insbesondere führen bevorzugt keine elektrischen Leiterbahnen und/oder Zuleitungen zu dem organischen lichtemittierenden Bauelement, um dieses mit Energie zu versorgen.

Bei einer Ausführungsform der Beleuchtungseinrichtung ist eine Steuereinheit, die das organische lichtemittierende Bauelement mittels eines elektromagnetischen Wechselfelds mit Energie versorgt, beispielsweise an einem Randbereich der Beleuchtungseinrichtung vorgesehen.

Beispielsweise ist das organische lichtemittierende Bauelement auf einem mittleren Bereich einer Glasplatte angeordnet. Bevorzugt ist dann der mittlere Bereich der Glasplatte, besonders bevorzugt die ganze Glasplatte, frei von elektrischen Zuleitungen, insbesondere von elektrischen Leiterbahnen.

Gemäß einem weiteren Aspekt der Erfindung umfasst eine Beleuchtungseinrichtung eine Mehrzahl von erfindungsgemäßen organischen lichtemittierenden Bauelementen. Diese sind in der Haupterstreckungsebene der Schichtstapel bevorzugt zumindest in einer Richtung bündig zueinander angeordnet und bilden zusammen eine oder mehrere Leuchtflächen. Die Leuchtfläche kann dabei entweder flach oder gekrümmt sein. Bei einer Ausführungsform stellt die Beleuchtungseinrichtung eine Anzeigevorrichtung dar.

Besonders bevorzugt besitzt der Schichtstapel eines Bauelements in seiner Haupterstreckungsebene, zumindest entlang der Richtung bzw. der Richtungen, in denen die Bauelemente bündig zueinander angeordnet sind, im Wesentlichen die gleiche Ausdehnung wie das Bauelement selbst. "Im Wesentlichen die gleiche Ausdehnung" beinhaltet dabei auch, dass das Bauelement beispielsweise einen Randbereich aufweist, an dem zum Beispiel Kappe und Substrat verklebt sind und der frei von dem Schichtstapel ist. Ein solcher Randbereich ist zweckmäßigerweise jedoch besonders schmal.

Es weisen die Außenflächen der Bauelemente bei dieser Ausführungsform keine elektrischen Kontaktflächen auf. Anders ausgedrückt gibt es weder Kontaktflächen, die in Draufsicht auf das Substrat seitlich neben dem Schichtstapel eines Bauelements angeordnet sind, noch sind elektrische Kontaktflächen auf der von der strahlungsemittierenden Seite abgewandten Rückseite der Bauelemente ausgebildet.

Die Fläche nicht leuchtender Bereiche zwischen den Schichtstapeln der einzelnen Bauelemente ist daher besonders klein oder nicht vorhanden. Der Betrachter nimmt vorteilhafterweise die Grenzen zwischen den einzelnen Bauelementen nicht oder nicht deutlich wahr. So können vorteilhafterweise große, im Wesentlichen gleichmäßig leuchtende Flächen mit organischen lichtemittierenden Bauelementen hergestellt werden. Zudem sind vorteilhafterweise keine elektrischen Leiterbahnen oder Ähnliches von dem verkapselten Innenraum des Bauelements nach außen geführt, die Permeationskanäle darstellen und entlang derer Wasser. Luftsauerstoff und/oder andere korrosive Stoffe in das Bauelement eindringen und zu einer beschleunigten Degradation des Schichtstapels führen. Die Beleuchtungseinrichtung ist daher besonders langlebig.

Im Gegensatz zu herkömmlichen Beleuchtungseinrichtungen bzw. Anzeigevorrichtungen ist es nicht notwendig, die einzelnen Bauelemente mittels Kabeln wie beispielsweise Flachbandkabeln mit einer Treiberelektronik elektrisch zu verbinden. So wird vorteilhafterweise die für die Produktion der Beleuchtungseinrichtung benötigte Zeit verkürzt und eine kostengünstigere Herstellung ist möglich.

Bei einer Ausführungsform umfasst die Beleuchtungseinrichtung eine oder mehrere Halterungen, in bzw. an denen die organischen lichtemittierenden Bauelemente angeordnet sind. Bevorzugt umfasst eine Halterung eine Steuereinheit, die ein organisches lichtemittierendes Bauelement oder eine Mehrzahl von Bauelementen mit Energie versorgt. Besonders bevorzugt ist jedem Bauelement eine Halterung und/oder eine Steuereinheit zugeordnet.

Bei einer Ausführungsform umfasst die Beleuchtungseinrichtung organische lichtemittierende Bauelemente, die in unterschiedlichen Spektralbereichen emittieren. Mit einer solchen Beleuchtungseinrichtung können in einfacher Weise unterschiedliche Muster erzeugt werden.

Ein erfindungsgemäßes Verfahren zur Herstellung eines erfindungsgemäßen organischen lichtemittierenden Bauelements umfasst die folgenden Schritte:
- Bereitstellen des Substrats;
- Herstellen des Schichtstapels, der die mindestens eine Schicht aufweist, die das organisches Material enthält und der geeignet ist, die elektromagnetische Strahlung zu erzeugen, auf dem Substrat;
- Aufbringen der Verkapselung auf das Substrat und den Schichtstapel,
wobei die Verkapselung derart aufgebracht wird, dass die Außenfläche des Bauelements frei von elektrischen Kontaktflächen ist.

Das Verfahren ermöglicht vorteilhafterweise die Herstellung eines besonders gut verkapselten organischen lichtemittierenden Bauelements. Zudem entfällt das Freilegen elektrischer Kontaktflächen auf der Außenfläche des Bauelements im Anschluss an die Herstellung des Schichtstapels, das bei der Herstellung herkömmlicher Bauelemente notwendig ist und die Produktionszeit und -kosten erhöht.

Das Substrat liegt zweckmäßigerweise in Form einer Platte oder einer Folie vor, wie oben beschrieben. Ein Substrat in Form einer Folie liegt vorzugsweise als fortlaufender Film vor, beispielsweise auf einer Rolle aufgewickelt. Auf diese Weise ist eine kostengünstige Herstellung der Bauelemente in einem "Endlosverfahren" (roll-to-roll Verfahren) möglich.

Vorzugsweise wird eine erste Elektrode auf dem Substrat abgeschieden. Bei der Herstellung einer Mehrzahl von Bauelementen mit dem Verfahren wird eine erste Elektrodenschicht strukturiert abgeschieden oder ganzflächig abgeschieden nach dem Abscheiden zu einzelnen ersten Elektroden strukturiert.

Auf der ersten Elektrode wird ein Schichtstapel hergestellt, der ein organisches Material, bevorzugt ein niedermolekulares Material ("small molecules") und/oder ein Polymer, umfasst. Niedermolekulare Materialien werden bevorzugt aufgedampft, Polymere bevorzugt nasschemisch, besonders bevorzugt mittels eines Drehschleuder-Verfahrens, (spin-coating), aufgebracht. Auch verschiedene Drucktechniken, beispielsweise Flachdruckverfahren wie der Offsetdruck, der Tampondruck, Hoch- und Tiefdruckverfahren wie beispielsweise der Flexodruck, oder Tintenstrahldruckverfahren, sind zum Aufbringen des Schichtstapels geeignet. Solche Druckverfahren sind beispielsweise in der Druckschrift WO 99/07189 A1 beschrieben.

Bei einer Ausführungsform wird eine organische Schichtenfolge vollflächig aufgebracht und nachfolgend stellenweise wieder von dem Substrat entfernt, so dass ein Schichtstapel, oder - bei der Herstellung einer Mehrzahl von Bauelementen - eine Mehrzahl von Schichtstapeln, verbleibt. Das stellenweise Entfernen der organischen Schichtenfolge erfolgt beispielsweise durch ein mechanisches Verfahren, z. B. mit Metallklingen. Alternativ kann auch ein Lösungsmittel benutzt werden, das beispielsweise durch eine Maske hindurch aufgebracht wird, oder die Schichtenfolge wird mittels Laserablation stellenweise wieder entfernt. Dabei wird bevorzugt ein Laser im ultravioletten Spektralbereich verwendet, besonders bevorzugt mit Wellenlängen zwischen 300 und 400 nm, wobei die Grenzen eingeschlossen sind. Bevorzugt wird auch ein Teilbereich der ersten Elektrode freigelegt.

Alternativ kann ein Schichtstapel bzw. eine Mehrzahl Schichtstapel auch durch strukturiertes Aufbringen einer organischen Schichtenfolge auf dem Substrat erzeugt werden. Hierzu eignen sich beispielsweise die oben genannten Druckverfahren. Insbesondere niedermolekulare organische Materialien können auch durch thermisches Verdampfen, insbesondere durch eine Maske hindurch, auf das Substrat aufgebracht werden. Bevorzugt bleibt ein Teilbereich der ersten Elektrode bei dem strukturierten Aufbringen von dem Schichtstapel unbedeckt.

Anschließend wird eine Verkapselung auf das Substrat und den Schichtstapel aufgebracht. Beispielsweise wird eine Folge von organischen und anorganischen Schichten, wie sie oben beschrieben sind, auf den Schichtstapel und auf das Substrat aufgebracht. Bevorzugt bedeckt die Folge von organischen und anorganischen Schichten die dem Schichtstapel zugewandte Seite des Substrats dabei vollständig.

Alternativ kann auch eine Verkapselung aufgebracht werden, die eine Platte oder eine Folie ist. Geeignete Materialien sind oben für das Bauelement ausgeführt. Handelt es sich bei der Verkapselung beispielsweise um eine Platte, so weist diese bevorzugt eine Vertiefung auf, die für die Aufnahme des Schichtstapels geeignet ist. Auf die dem Schichtstapel zugewandte Seite der Verkapselung kann, ggf. insbesondere im Bereich der Vertiefung, ein Gettermaterial aufgebracht werden, wie oben beschrieben. Die Verkapselung braucht dabei vorteilhafterweise keine Aussparungen, z. B. für elektrische Kontaktflächen an der Außenfläche des Bauelements, aufzuweisen. Besonders bevorzugt hat sie in der Haupterstreckungsebene des Schichtstapels dieselben Abmessungen wie das Substrat.

Bei der Herstellung einer Mehrzahl von organischen lichtemittierenden Bauelementen mit dem Verfahren erfolgt das Verkapseln bevorzugt, indem eine zusammenhängende Verkapselung auf eine Mehrzahl von Schichtstapeln aufgebracht wird. Bei der zusammenhängenden Verkapselung handelt es sich bevorzugt um eine Mehrzahl von Verkapselungen einzelner Bauelemente, die integriert ausgebildet sind. Bevorzugt stellt die zusammenhängende Verkapselung ein einfach zusammenhängendes Gebiet dar und weist keine Aussparungen auf. Besonders bevorzugt wird sie ganzflächig auf das Substrat aufgebracht.

Bei einer Ausführungsform wird der Verbund, der das Substrat, die Schichtstapel und die zusammenhängende Verkapselung umfasst, mittels Schnitten zu einzelnen organischen lichtemittierenden Bauelementen vereinzelt, die sowohl das Substrat als auch die zusammenhängende Verkapselung durchtrennen. Wenn die erste Elektrodenschicht nicht in einem vorhergehenden Verfahrensschritt bereits strukturiert worden ist, können die Schnitte zugleich auch die erste Elektrodenschicht zu einzelnen ersten Elektroden strukturieren. Das Verfahren ermöglicht damit vorteilhafterweise eine einfache Vereinzelung des Verbundes zu einzelnen Bauelementen mittels geradliniger Schnitte.

Die Verbindung des Substrats mit der Verkapselung erfolgt beispielsweise mittels eines Klebstoffs, der auf das Substrat und/oder die Verkapselung, bevorzugt in Form einer Kleberaupe, stellenweise aufgebracht wird. Bei dem Klebstoff handelt es sich bevorzugt um einen thermisch und/oder optisch härtbaren Klebstoff, beispielsweise auf Basis eines Epoxidharzes oder auf Basis von Lötglas. Das Aushärten erfolgt beispielsweise durch Erwärmen und/oder durch Bestrahlen mit elektromagnetischer Strahlung, insbesondere im infraroten und/oder ultravioletten Spektralbereich. Bei einer Ausführungsform handelt es sich bei der elektromagnetischen Strahlung um Laserstrahlung. Die elektromagnetische Strahlung wird vorzugsweise fokussiert und/oder stellenweise abgeschattet, so dass beispielsweise im Wesentlichen nur die mit Klebstoff bedeckten Stellen des Substrats und/oder der Verkapselung bestrahlt werden. Solche Verfahren sind zur Verkapselung einzelner Bauelemente beispielsweise in der Druckschrift US 2006-0105493 A1 beschrieben.

Die Bestrahlung des Klebstoffs erfolgt dabei durch das Substrat und/oder durch die Verkapselung hindurch. Vorteilhafterweise gibt es keine dem Klebstoff benachbarten Leiterbahnen, elektrischen Zuleitungen, oder Ähnliches. Solche elektrischen Zuleitungen und/oder Leiterbahnen stören bei üblichen Verfahren zur Herstellung von organischen lichtemittierenden Bauelementen das Aushärten des Klebstoffs. Beispielsweise haben sie in der Regel andere optische, thermische und/oder physikalische Eigenschaften als das Substrat und/oder die Verkapselung. Da der Klebstoff vorliegend nicht über elektrische Zuleitungen und/oder Leiterbahnen verläuft und auch nicht durch solche hindurch bestrahlt werden muss, erfolgt die Bestrahlung bzw. Erwärmung des Klebstoffs an allen Stellen möglichst gleichmäßig und es wird ein homogenes Aushärten des Klebstoffs erreicht. So ist eine besonders hermetische Verkapselung möglich.

Alternativ kann die Verkapselung mit dem Substrat beispielsweise durch Zufuhr von Wärme und/oder mittels einer geeigneten chemischen Reaktion, die beispielsweise die Verkapselung und/oder das Substrat anlöst, insbesondere mittels eines Ätzprozesses, verschmolzen bzw. verbunden werden. Vorteilhafterweise verlaufen im Gegensatz zu herkömmlichen Bauelementen in dem zu verbindenden Bereich keine elektrischen Leiterbahnen und/oder Kontaktflächen, die bei der Verwendung solcher Verbindungstechniken abgelöst oder zerstört werden könnten.

Weitere Vorteile und vorteilhaften Ausführungsformen und Weiterbildungen der Erfindung ergeben sich aus den im Folgenden in Verbindung mit den Figuren 1A bis 7 beschriebenen Ausführungsbeispielen.

Es zeigen:
Figuren 1A bis 1F, schematische Querschnitte durch eine Mehrzahl von organischen lichtemittierenden Bauelementen bei verschiedenen Stadien gemäß einem Ausführungsbeispiel des erfindungsgemäßen Verfahrens,
Figuren 2A und 2B, schematische Draufsichten auf ein Bauelement bei den in den Figuren 1B und 1C dargestellten Stadien des Verfahrens,
Figur 2C, eine schematische Draufsicht auf ein Bauelement gemäß einer Variante des ersten Ausführungsbeispiels,
Figur 3A, einen schematischen Querschnitt durch ein organisches lichtemittierendes Bauelement gemäß einem weiteren Ausführungsbeispiel,
Figur 3B, eine schematische Draufsicht auf das organische lichtemittierende Bauelement der Figur 3A,
Figur 3C, eine schematische Draufsicht auf ein organisches lichtemittierendes Bauelement gemäß einer Abwandlung der Erfindung,
Figur 4, einen schematischen Querschnitt durch ein organisches lichtemittierendes Bauelement gemäß einer Abwandlung der Erfindung,
Figur 5A, einen schematischen Querschnitt durch eine Vorrichtung mit einem organischen lichtemittierenden Bauelement gemäß einem ersten Ausführungsbeispiel,
Figur 5B, einen schematischen Querschnitt durch eine Vorrichtung mit einem organischen lichtemittierenden Bauelement gemäß einem weiteren Ausführungsbeispiel,
Figur 5C, einen schematischen Querschnitt durch eine Vorrichtung mit einem organischen lichtemittierenden Bauelement gemäß einer Variante des Ausführungsbeispiels der Figur 5B,
Figur 6, eine schematische Draufsicht auf einen Ausschnitt einer Beleuchtungseinrichtung gemäß einem ersten Ausführungsbeispiel, und
Figur 7, eine schematische Draufsicht auf einen Ausschnitt einer Beleuchtungseinrichtung gemäß einem zweiten Ausführungsbeispiel.

In den Ausführungsbeispielen und Figuren sind gleiche oder gleich wirkende Bestandteile jeweils mit den gleichen Bezugszeichen versehen. Die dargestellten Elemente und deren Größenverhältnisse untereinander sind grundsätzlich nicht als maßstabsgerecht anzusehen, vielmehr können einzelne Elemente, wie z. B. Schichten und/oder Ränder, zur besseren Darstellbarkeit und/oder zum besseren Verständnis übertrieben dick bzw. groß dargestellt sein.

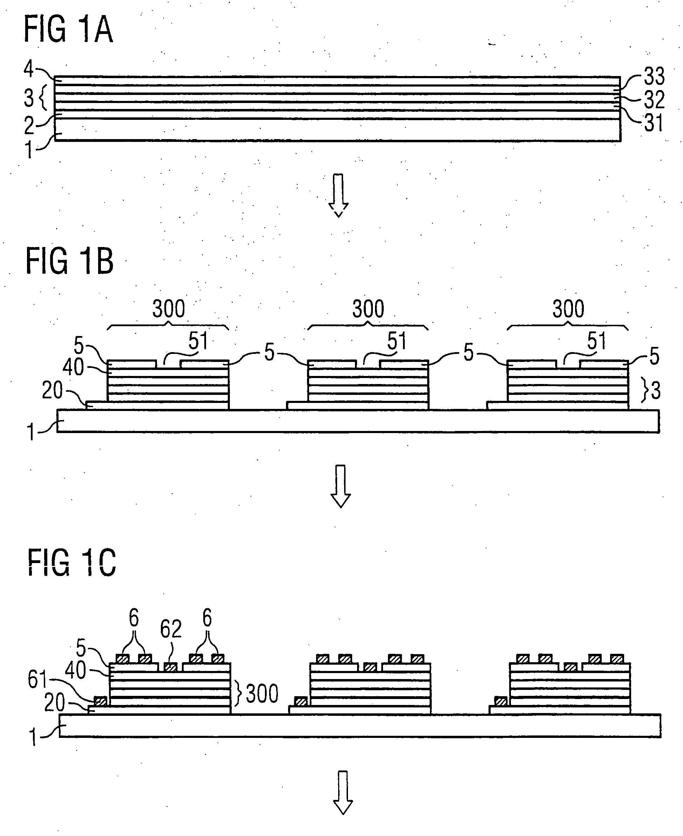

Gemäß einem Ausführungsbeispiel des erfindungsgemäßen Verfahrens wird ein Substrat 1 bereitgestellt, bei dem es sich vorliegend um eine Glasplatte handelt. Auf das Substrat 1 wird, wie in Figur 1A dargestellt, eine erste Elektrodenschicht 2 aufgebracht. Vorliegend handelt es sich dabei um eine Schicht aus Indium-Zinn-Oxid (ITO), die mittels eines Sputter-Prozesses auf dem Substrat 1 abgeschieden wird. Aus der ersten Elektrodenschicht 2 werden bei diesem Ausführungsbeispiel in einem nachfolgenden Prozessschritt durch Strukturieren erste Elektroden 20 hergestellt, die Anoden sind.

Auf die erste Elektrodenschicht 2 wird vorliegend mittels eines Verdampfungsprozesses eine organische Schichtenfolge 3 aufgebracht. Die Schichtenfolge 3 umfasst insbesondere eine der ersten Elektrodenschicht 2 benachbarte Lochtransportschicht 31, die beispielsweise 1-Naphdata und/oder α-NPD enthält. Weiter umfasst die aktive Schichtenfolge 3 eine zur Strahlungserzeugung geeignete aktive Schicht 32, die vorliegend ein zur Emission von elektromagnetischer Strahlung geeignetes niedermolekulares Material wie Alq₃ und/oder DPVBi enthält. Weiter umfasst die aktive Schichtenfolge 3 eine Elektronentransportschicht 33, die beispielsweise Alq₃ und/oder BPhen aufweist. Dieser ist eine zweite Elektrodenschicht 4 benachbart, die nachfolgend ebenfalls mittels eines Verdampfungsprozesses auf die organische Schichtenfolge 3 aufgebracht wird.

Alternativ kann die Schichtenfolge 3 auch mittels eines Drehschleuder-Verfahrens aufgebracht werden. Die Schichtenfolge 3 umfasst dann beispielsweise nur zwei Schichten, die beispielsweise ein Polymer aufweisen: eine der ersten Elektrodenschicht 2 benachbarte Lochtransportschicht 31 und eine aktive Schicht 32. Beispielsweise weist die Lochtransportschicht 31 PEDOT auf und/oder die aktive Schicht 32 weist PPV und/oder Polyfluoren auf. Bei einer anderen Ausführungsform umfasst die Schichtenfolge zusätzlich mindestens eine dritte Schicht, beispielsweise eine Elektronentransportschicht 33. Zumindest in diesem Fall weist die Schichtenfolge bevorzugt wenigstens ein vernetzbares Polymer auf. Beispielsweise ist das vernetzbare Polymer durch Bestrahlen mit elektromagnetischer Strahlung vernetzbar, anders ausgedrückt photovernetzbar. Nach dem Vernetzen des vernetzbaren Polymers ist die Schicht, die das vernetzbare Polymer enthält mit Vorteil unlöslich in einem Lösungsmittel, das für das Aufbringen der folgenden Schicht verwendet wird.

Die Dicke der organischen Schichtenfolge 3 ist bevorzugt kleiner oder gleich 500 nm, besonders bevorzugt kleiner oder gleich 200 nm.

Aus der zweiten Elektrodenschicht 4 werden vorliegend Kathoden 40 durch nachfolgendes Strukturieren hergestellt.

Die zweite Elektrodenschicht 4 umfasst eine dünne Injektionsschicht eines Alkali- oder Erdalkalimetalls, beispielsweise Kalzium, und eine Deckschicht, die vorliegend Aluminium und/oder Silber beinhaltet.

Nachfolgend wird, wie in Figur 1B dargestellt, die organische Schichtenfolge 3 zu einzelnen Schichtstapeln 300 strukturiert, wobei vorliegend auch ein Teilbereich der ersten Elektrodenschicht 2 freigelegt wird. Die Strukturierung erfolgt beispielsweise durch Laserablation. Bei diesem Verfahrensschritt werden vorliegend auch die zweite Elektrodenschicht 4 und die erste Elektrodenschicht 2 zu zweiten Elektroden 40 und ersten Elektroden 20 strukturiert. Alternativ können die erste und/oder die zweite Elektrodenschicht 2, 4 bereits beim Aufbringen strukturiert werden. Die Strukturierung der organischen Schichtenfolge 3 zu einzelnen Schichtstapeln 300 kann alternativ auch vor dem Aufbringen der zweiten Elektrodenschicht 4 erfolgen.

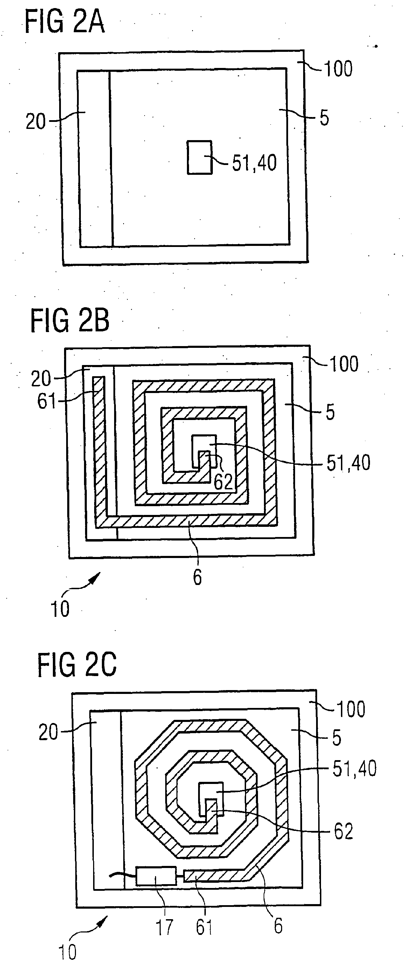

Nachfolgend wird auf die zweite Elektrode 40 eines Schichtstapels 300 eine isolierende Schicht 5 aufgebracht. Dieser Verfahrensschritt und die nachfolgende Verfahrensschritte werden bevorzugt bei einer Mehrzahl von Schichtstapeln 300, besonders bevorzugt bei allen Schichtstapeln 300, zu gleichen Zeiten oder sequentiell ausgeführt. Die isolierende Schicht weist vorliegend eine Ausnehmung 51 auf, die einen mittleren Bereich der zweiten Elektrode 40 frei lässt (vgl. auch Fig. 2A). Beispielsweise wird die isolierende Schicht durch Verdampfen oder Sputtern aufgebracht. Sie weist zum Beispiel Al₂O₃, Polytetrafluorethylen, PS und/oder PMMA auf oder besteht aus einem dieser Materialien. Alternativ kann es sich bei der isolierenden Schicht auch um eine selbstorganisierte Monolage handeln.

Auf dem freigelegten Teilbereich der ersten Elektrode 20, der isolierenden Schicht 5 und dem mittleren Teil der zweiten Elektrode 40 wird, vorzugsweise mittels Aufdampfen durch eine Maske hindurch, eine Leiterbahn 6 erzeugt (vgl. Fig. 1C). Beispielsweise enthält die Leiterbahn Aluminium, Silber, Gold und/oder Kupfer oder besteht aus einem dieser Materialien. Sie hat vorliegend die Form einer rechteckigen Spirale, wie in Figur 2B dargestellt.

Ein erstes Ende 61 der Leiterbahn befindet sich auf dem freigelegten Teilbereich der ersten Elektrode 20 und ein zweites Ende 62 der Leiterbahn befindet sich auf dem mittleren Bereich der zweiten Elektrode 40, in der Ausnehmung 51 der isolierenden Schicht 5. Die Leiterbahn 6 stellt eine Antenne dar, die die erste und die zweite Elektrode 20, 40 vermittels ihrer Enden 61, 62 elektrisch leitend verbindet. Das Substrat 1 ist vorliegend frei von weiteren Leiterbahnen.

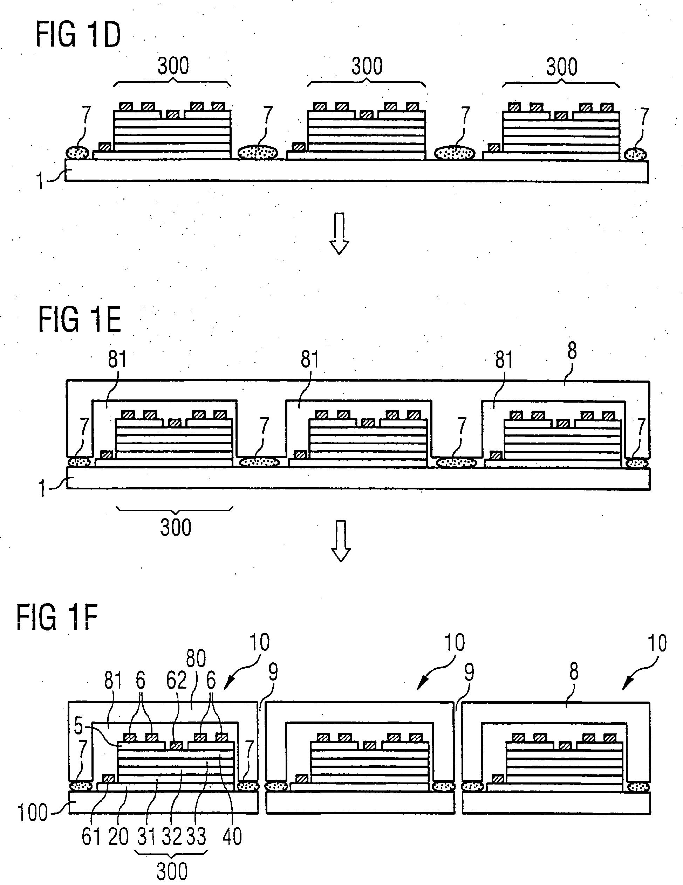

Nachfolgend wird, wie in Figur 1D gezeigt, auf das Substrat 1 stellenweise ein Klebstoff aufgebracht. Bevorzugt umschließt der Klebstoff den Schichtstapel 300 in der Haupterstreckungsebene des Substrats 1 vollständig. Der Klebstoff ist zum Beispiel durch Bestrahlen, beispielsweise mit ultravioletter oder infraroter Strahlung, und/oder durch Erwärmen härtbar. Bei dem Klebstoff 7 handelt es sich beispielsweise um ein Epoxidharz.

Nachfolgend wird eine zusammenhängende Verkapselung 8 auf das Substrat 1 aufgebracht (vgl. Fig. 1E). Die zusammenhängende Verkapselung 8 besteht vorliegend aus Glas und weist Vertiefungen 81 auf, die geeignet sind, je einen Schichtstapel 300 aufzunehmen. Die zusammenhängende Verkapselung 8 wird so auf dem Substrat 1 angeordnet, dass die Halbleiterschichtstapel 300 in den Vertiefungen 81 zu liegen kommen. Vorliegend ist die Ausdehnung des Substrats 1 und der zusammenhängenden Verkapselung 8 in der Haupterstreckungsebene des Substrats 1 gleich groß, und das Substrat 1 und die zusammenhängende Verkapselung 8 sind bündig zueinander angeordnet, sodass sie in Draufsicht auf das Substrat 1 deckungsgleich sind. Die zwischen den Vertiefungen 81 angeordneten Bereiche der dem Substrat 1 zugewandten Seite der zusammenhängenden Verkapselung 8 werden zumindest teilweise von dem Klebstoff 7 benetzt.

Nachfolgend wird der Kleber 7 ausgehärtet, sodass eine mechanisch stabile Verbindung zwischen der zusammenhängenden Verkapselung 8 und dem Substrat 1 entsteht. Der Schichtstapel 300 wird dabei derart in der Vertiefung 81 eingeschlossen, dass Wasser, Luftsauerstoff und andere korrosive Stoffe möglichst nicht aus dem Außenraum in die Vertiefung 81 eindringen können.

Das Aushärten des Klebstoffs 7 erfolgt beispielsweise durch Bestrahlung mit elektromagnetischer, insbesondere ultravioletter, Strahlung. Die Bestrahlung erfolgt zum Beispiel mittels einer UV-Lampe, insbesondere bei großflächiger Bestrahlung, oder mittels eines Lasers, dessen Strahlung insbesondere fokussiert wird. Dies ist beispielsweise in der Druckschrift US 2006-0105493 A1 beschrieben. Die Bestrahlung des Klebstoffs 7 erfolgt dabei durch das Trägersubstrat 1 und/oder durch die zusammenhängende Verkapselung 8 hindurch. Vorteilhafterweise befinden sich dabei an den zu verklebenden Stellen keine Leiterbahnen oder Ähnliches im Strahlengang der elektromagnetischen Strahlung, sodass die Bestrahlung des Klebstoffs 7 an allen Stellen möglichst gleichmäßig erfolgt. So wird ein homogenes Aushärten des Klebstoffs 7 erreicht, wodurch eine besonders hermetische Verkapselung erzielt wird. Nachfolgend werden die Schichtstapel 300 mittels Schnitten 9 durch die zusammenhängende Verkapselung 8, den Klebstoff 7 und das Substrat 1 zu einzelnen organischen lichtemittierenden Bauelementen 10 vereinzelt (vgl. Fig. 1F). Erst bei diesem Verfahrensschritt wird vorliegend das Substrat 1, also das Trägersubstrat für die Mehrzahl der Schichtstapel, zu einzelnen Substraten 100 und die zusammenhängende Verkapselung 8 zu einzelnen Kappen 80 strukturiert.

Erfindungsgemäß weist das Bauelement 10 keine äußeren Kontaktflächen auf. Daher entfällt ein aufwendiges Entfernen der organischen Schichtenfolge von solchen Kontaktflächen und es muss auch kein Teilbereich des Substrats 100 zur Aufnahme solcher Kontaktflächen vorgesehen sein. Die Kappe 80 und das Substrat 100 können daher, wie in Figur 1F gezeigt, formschlüssig angeordnet sein. Zudem gibt es keine elektrischen Leiterbahnen, die zwischen der Kappe 80 und dem Substrat 100 aus dem von der Vertiefung 81 der Kappe 80 gebildeten Innenraum des Bauelements in den Außenraum geführt werden müssen, und die bei organischen lichtemittierenden Bauelementen herkömmlicher Bauart Diffusionskanäle darstellen können, entlang derer Sauerstoff und Wasser in den Innenraum 81 des Bauteils eindringen können und die Alterung des Schichtstapels 300 beschleunigen.

Bei einer Variante dieses Ausführungsbeispiels hat die Antenne 6 Form einer achteckigen Spirale, wie in Figur 2C dargestellt.

Beispielhaft ist in Figur 2C auch ein elektronisches Bauelement 17 dargestellt, das vorliegend zwischen der ersten Elektrode 20 und dem ersten Ende 61 der Antenne 6, beispielsweise auf der von dem Substrat 100 abgewandten Seite des Schichtstapels 300, angeordnet ist. Alternativ kann es auch seitlich neben dem Schichtstapel 300 auf dem Substrat 100 angeordnet sein.

Beispielsweise handelt es sich bei dem elektronischen Bauelement 17 um eine Diode, die zur Gleichrichtung des in den Schichtstapel 300 eingeprägten Stroms vorgesehen ist. Die Diode 17 ist elektrisch leitend mit der ersten Elektrode 20 und dem ersten Ende 61 der Antenne 6 verbunden, insbesondere mittels Bonden oder Löten beispielsweise von Anschlussdrähten und schließt so den Stromkreis.

Alternativ dazu kann ein solches elektronisches Bauelement 17 bzw. eine Schaltung aus mehreren solcher Bauelemente 17 auch als Schichtstruktur, anders ausgedrückt als Folge von, insbesondere strukturierten, Schichten wie Halbleiterschichten, ausgebildet sein. Beispielsweise ist die Schichtstruktur, die bevorzugt eine epitaktische Halbleiterschichtenfolge umfasst, zwischen dem Schichtstapel 300 und der ersten Elektrode 20 angeordnet.

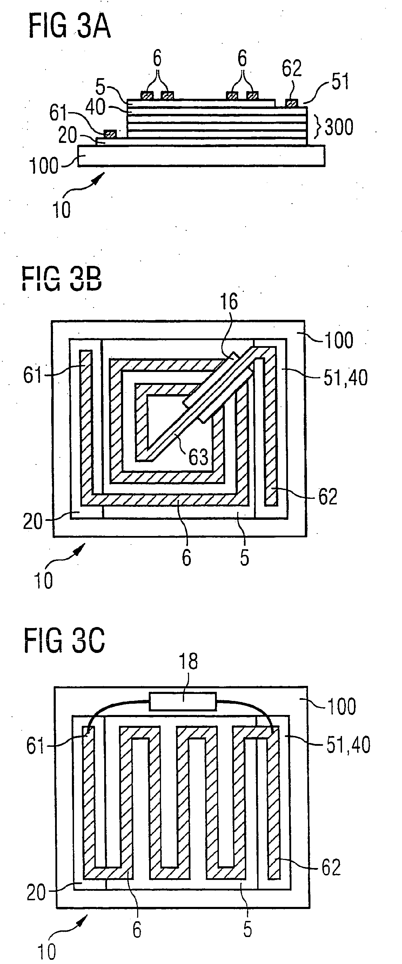

Bei einem organischen lichtemittierenden Bauelement 10 gemäß dem Ausführungsbeispiel der Figuren 3A und 3B bleibt statt eines mittleren Bereichs, wie beim vorhergehenden Ausführungsbeispiel, ein Randbereich 51 der zweiten Elektrode 40 von der isolierenden Schicht 5 unbedeckt. Die Antenne ist als rechteckige Spirale aus Leiterbahnen ausgeführt. Ausgehend von einem ersten Ende 61 der Leiterbahn 6, das elektrisch leitend mit der ersten Elektrode 20 verbunden ist, sind auf der isolierenden Schicht 5 Windungen ausgebildet, die spiralförmig von einem Randbereich der isolierenden Schicht 5 zu einem mittleren Bereich der isolierenden Schicht 5 verlaufen. Von dort verläuft ein Verbindungsstück 63 der Leiterbahn 6 wieder zum Rand der isolierenden Schicht 5 und geht in ein zweites Ende 62 über, das in der Ausnehmung 51 der isolierenden Schicht 5 angeordnet und elektrisch leitend mit der zweiten Elektrode 40 verbunden ist. Zwischen dem Verbindungsstück 63 und den Windungen der Antenne 6 ist eine Trennschicht 16 angeordnet, die das Verbindungsstück 63 gegen die Windungen, über die es verläuft, elektrisch isoliert. So wird ein Kurzschluss der Antenne 6 durch das Verbindungsstück 63 verhindert.

In Figur 3C ist eine nicht erfindungsgemäße Abwandlung dargestellt. Im Unterschied zu dem Ausführungsbeispiel der Figuren 3A und 3B ist die Leiterbahn 6 ist bei dieser Abwandlung in der Art einer Rechteckswelle ausgebildet, die elektrisch leitend mit dem freiliegenden Teil der ersten Elektrode 20 verbunden ist und sich von dort zu der auf der gegenüberliegenden Seite des organischen Schichtstapels 300 angeordneten Ausnehmung 51 der isolierenden Schicht 5 erstreckt, wo sie mit der zweiten Elektrode 40 ebenfalls elektrisch leitend verbunden ist.

Beispielhaft zeigt die Figur 3C auch ein datenspeicherndes Bauelement 18, beispielsweise einen Folienkondensator mit Soll-Kurzschlussstelle oder einen RFID-Chip, das in Parallelschaltung zu dem Schichtstapel 300 mit dem ersten Ende 61 und dem zweiten Ende 62 der Antenne 6 elektrisch verbunden ist, beispielsweise mittels Anschlussdrähten und/oder durch Löten bzw. Bonden. So wird das von der Antenne 6 empfangene elektromagnetische Wechselfeld vorteilhafterweise auch in das datenspeichernde Bauelement 18 eingekoppelt. Beispielsweise ist das datenspeichernde Bauelement 18 neben dem Schichtstapel 300 auf dem Substrat 100 angeordnet oder es ist der vom Substrat 100 abgewandten Seite des Schichtstapels 300 benachbart.

Auch ein elektronisches Bauelement 17, das beispielsweise ein zur Spannungsglättung vorgesehener Kondensator ist, kann wie das datenspeichernde Bauelement 18 in Parallelschaltung zu dem Schichtstapel 300 elektrisch angeschlossen sein.

Die Ausgestaltungen der Ausnehmungen 51 und der Antenne 6 sind nicht auf die in dem ersten und zweiten Ausführungsbeispiel beschriebenen Geometrien beschränkt. Vielmehr können sie den jeweiligen Anforderungen entsprechend angepasst werden.

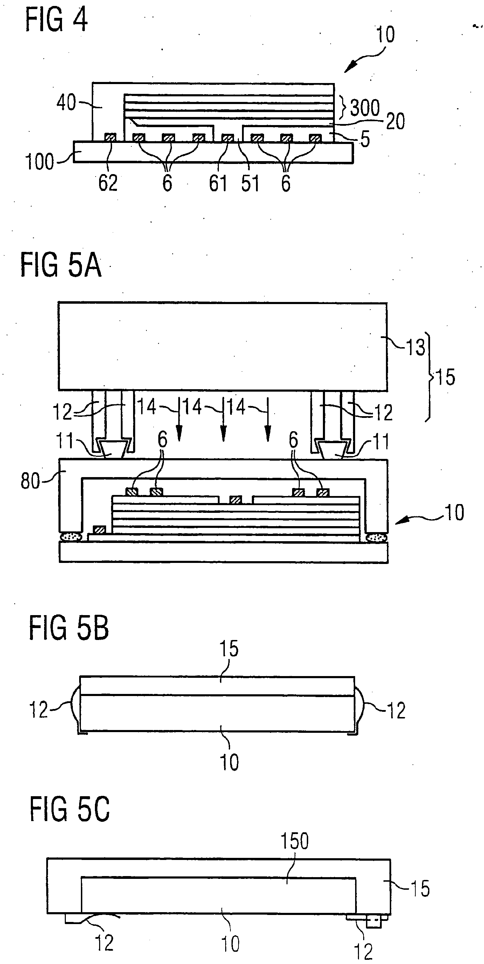

Bei der in Figur 4 dargestellten Abwandlung ist die Antenne 6 nicht wie bei den ersten beiden Ausführungsbeispielen auf der von dem Substrat 100 abgewandten Seite der zweiten Elektrode 40 angeordnet. Stattdessen befindet sie sich zwischen dem Substrat 100 und dem Schichtstapel 300.

Nachfolgend auf die Antenne 6 ist die erste Elektrode 20 angeordnet. Eine isolierende Schicht 5 trennt die Antenne 6 von der ersten Elektrode 20. Dabei weist die isolierende Schicht 5 eine Ausnehmung 51 auf, in die hinein sich die erste Elektrode 20 erstreckt. Ein erstes Ende 61 der Antenne 6 befindet sich ebenfalls in der Ausnehmung 51, sodass ein elektrischer Kontakt zwischen der ersten Elektrode 20 und der Antenne 6 hergestellt wird.

Nachfolgend auf die erste Elektrode 20 ist der Schichtstapel 300 aufgebracht, auf diesen folgt die zweite Elektrode 40.

Das zweite Ende 62 der Antenne 6 ragt bei diesem Ausführungsbeispiel seitlich über den Schichtstapel 300 hinaus, sodass ein Kontakt mit der zweiten Elektrode 40 hergestellt wird, die vorliegend nicht nur auf dem Schichtstapel 200 angeordnet ist, sondern auch seitlich über diesen zu dem zweiten Ende 62 der Antenne 6 gezogen ist. Während bei dem organischen lichtemittierenden Bauelement gemäß den Ausführungsbeispielen und Abwandlungen gemäß den Figuren 1A bis 3C eine von dem Schichtstapel 300 im Betrieb erzeugte elektromagnetische Strahlung im Wesentlichen durch die erste Elektrode 20 und das Substrat 100 ausgekoppelt wird ("bottom-emitter"), erfolgt die Auskopplung der elektromagnetischen Strahlung bei dem Bauelement 10 gemäß der Abwandlung der Figur 4 vorzugsweise im Wesentlichen durch die zweite Elektrode 40 ("top-emitter"). Bei dieser Abwandlung braucht daher das Substrat 100 nicht transparent zu sein. Die erste Elektrode 20 weist bevorzugt einen möglichst hohen Reflexionskoeffizienten auf. Dagegen ist die zweite Elektrode 40 bevorzugt für eine von dem Schichtstapel 300 im Betrieb erzeugte elektromagnetische Strahlung zumindest teilweise durchlässig. Bei einer zweckmäßigen Ausgestaltung der Abwandlung der Figur 4 stellt die zweite Elektrode 40 die Anode dar und besteht beispielsweise aus Indium-Zinn-Oxid. Die erste Elektrode 20 stellt dann bevorzugt die Kathode dar und umfasst beispielsweise Aluminium.

Die Vorrichtung gemäß dem in der Figur 5A dargestellten ersten Ausführungsbeispiel umfasst ein organisches lichtemittierendes Bauelement 10, das mittels Haltemitteln 11 in einer Halterung 15 angeordnet ist. Die Haltemittel 11 sind vorliegend als Vorsprünge in der Verkapselung 80 ausgebildet. Diese Vorsprünge 11 rasten in passenden Ausnehmungen von flexiblen Stützmitteln 12 der Halterung 15 - bevorzugt formschlüssig - ein.

So kann eine einfache und reproduzierbare Ausrichtung des Bauelements 10 erreicht werden. Gleichzeitig kann es in einfacher Weise aus der Halterung 15 entfernt werden. So ist einerseits ein einfacher Austausch im Defektfall gewährleistet, andererseits ist eine hohe Variabilität gewährleistet, die dem Anwender den Einsatz von Bauelementen 10 mit unterschiedlichen Farben und/oder Formen erlaubt, die einfach gegeneinander ausgetauscht werden können.

Vorliegend umfasst die Halterung 15 auch eine Steuereinheit 13, die das organische lichtemittierende Bauelement 10 mit Energie versorgt. Die Steuereinheit 13 und das Bauelement 10 sind nicht elektrisch leitend verbunden. Vielmehr erfolgt die Energieversorgung durch ein von der Steuereinheit 13 mittels einer Spule und/oder Antenne aus einem Wechselstrom oder einem zeitlich variierenden Gleichstrom erzeugtes elektromagnetisches Wechselfeld (angedeutet durch Pfeile 14), das von der Steuereinheit 13 abgestrahlt wird. Das elektromagnetische Wechselfeld 14 wird vorliegend induktiv in das organische lichtemittierende Bauelement 10 eingekoppelt und von der Empfängervorrichtung, die vorliegend eine aus Leiterbahnen 6 gebildete Antenne umfasst, empfangen. Die Antenne 6 entnimmt dem elektromagnetischen Wechselfeld 14 Energie und wandelt diese in elektrische Energie um. So wird ein Strom in den Schichtstapel 300 eingeprägt, der die aktive Schicht 32 zur Emission von elektromagnetischer Strahlung anregt.

Ein fehleranfälliges und zeitaufwendiges elektrisches Kontaktieren mittels Bondpads oder Ähnlichem an den Außenflächen des Bauelements ist mit Vorteil nicht notwendig.

Bei der Vorrichtung gemäß dem Ausführungsbeispiel der Figur 5B ist das organische lichtemittierende Bauelement 10 mit Stützmitteln 12, beispielsweise Metallklammern, an der Haltevorrichtung 15, befestigt, insbesondere einfach lösbar befestigt. Die Halterung 15 weist vorteilhafterweise eine geringe Bauhöhe auf. Vorliegend ist eine Außenfläche der Halterung 15 einer Hauptfläche der Verkapselung 80 oder des Substrats 100 benachbart, insbesondere grenzen sie aneinander an. So wird mit Vorteil eine besonders geringe Höhe der Vorrichtung erzielt.

Bei der in Figur 5C dargestellten Variante dieser Ausführungsform ist das organische lichtemittierende Bauelement 10 in einer Ausnehmung 150 der Halterung 15 angeordnet. Vorzugsweise füllt das Bauelement 10 die Ausnehmung 150 teilweise oder vollständig aus. Insbesondere liegen die von der Halterung 15 freigelassene Außenfläche des Bauelements 10 und der die Vertiefung 150 umgebende Teilbereich der Fläche der Halterung 15, welche die Vertiefung 150 enthält, im Wesentlichen in einer Ebene. Beispielsweise fixiert wenigstens ein Stützmittel 12 das Bauelement 10 in der Halterung 15.

In Figur 5C ist als Stützmittel auf der linken Seite der Figur beispielhaft eine Metallklammer 12 abgebildet, die an dem die Vertiefung 150 umgebenden Teilbereich der Halterung 15 befestigt ist und sich über die Kante des Bauelements 10 auf dessen von der Halterung 15 freigelassene Fläche erstreckt.

Auf der rechten Seite der Figur ist beispielhaft ein Riegel 12, der beispielsweise aus einem Kunststoffmaterial besteht, dargestellt. Der Riegel 12 ist so an der Halterung 15 befestigt, dass er parallel zu der freigelassenen Fläche des Bauelements 10 beweglich ist. Mit einem solchen Riegel 12 ist eine besonders einfache Auswechslung des Bauelements 10 möglich.

Beispielsweise bei einem organischen lichtemittierenden Bauelement, das ein Sicherungs-Etikett ist, erfolgt die Verbindung des Bauelements 10 mit der Halterung 15, insbesondere einer zu sichernden Ware, zum Beispiel mittels eines Klebstoffs. Die Verbindung ist in diesem Fall vorzugsweise nicht einfach lösbar.

Insbesondere wenn die Vorrichtung, wie in diesem Fall, ein organisches lichtemittierendes Bauelement 10 mit einem datenspeichernden Bauelement 10 umfasst, enthält die Halterung 15 vorzugsweise nicht die Steuereinheit 13. Vorzugsweise wird es in ein von der Steuereinheit 13 mit dem elektromagnetischen Wechselfeld 14 bestrahltes Gebiet eingebracht, beispielsweise auf einer Fläche abgelegt oder an einer Fläche vorbeigeführt.

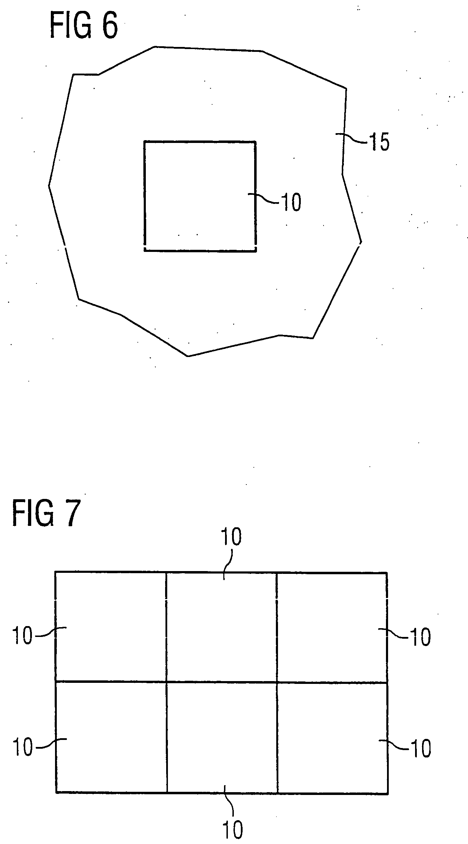

Eine Beleuchtungseinrichtung gemäß dem in Figur 6 dargestellten ersten Ausführungsbeispiel umfasst ein organisches lichtemittierendes Bauelement 10, das vorliegend vollflächig mit einer Halterung 15, wie einer Glasplatte, verbunden ist. Die Verbindung kann beispielsweise mittels eines Klebefilms hergestellt werden. Die Halterung 15 enthält dabei keine dem organischen lichtemittierenden Bauelement 10 benachbarten elektrischen Leiterbahnen oder Zuleitungen. Insbesondere führen keine elektrischen Leiterbahnen und/oder Zuleitungen zu dem organischen lichtemittierenden Bauelement, um dieses mit Energie zu versorgen.

Bei einer Variante dieses Ausführungsbeispiels umfasst die Halterung 15 eine Steuereinheit 13, die eine Mikrowellenanlage darstellt. Beispielsweise umfasst eine solche Mikrowellenanlage einen Innenraum, in den Gegenstände eingebracht werden können, um mit dem von der Mikrowellenanlage erzeugten elektromagnetischen Wechselfeld bestrahlt zu werden, und eine Tür, die den Innenraum verschließt und die zum Beispiel zumindest stellenweise lichtdurchlässig ist.

Das organische lichtemittierende Bauelement 10 ist vorliegend in dem Innenraum der Mikrowellenanlage angeordnet, bevorzugt auf der dem Innenraum zugewandten Seite der Tür der Mikrowellenanlage, insbesondere an einer lichtdurchlässigen Stelle der Tür. Auf diese Weise wird das von der Mikrowellenanlage 13 erzeugte elektromagnetische Wechselfeld 14 induktiv in das Bauelement 10 eingekoppelt, sodass dieses mit Energie versorgt wird. Ein solches organisches lichtemittierendes Bauelement ist besonders gut dazu geeignet, den Betriebszustand der Mikrowellenanlage 13 anzuzeigen.

Bei einer weiteren Variante ist das Hochfrequenzgerät ein Induktionsherd. Der Induktionsherd weist beispielsweise eine Kochfläche 15 auf. Das organische lichtemittierende Bauelement 10 ist beispielsweise auf der Kochfläche 15 angeordnet. Es befindet sich innerhalb des von dem Hochfrequenzgerät mit dem elektromagnetischen Wechselfeld bestrahlten Gebiet und zeigt mit Vorteil den Betriebszustand des Induktionsherds an.

Anstelle eines einzelnen organischen lichtemittierenden Bauelements 10 kann beispielsweise eine Mehrzahl von Bauelementen 10 zur Anzeige des Betriebszustands des Hochfrequenzgeräts vorgesehen sein. Insbesondere sind die Bauelemente 10 in diesem Fall so ausgeführt, dass aus dem Leuchtmuster der Bauelemente die Intensität des elektromagnetischen Wechselfelds abgelesen werden kann.

Eine Beleuchtungseinrichtung gemäß einem zweiten Ausführungsbeispiel umfasst eine Mehrzahl von organischen lichtemittierenden Bauelementen 10. Diese sind in der Haupterstreckungsebene der Schichtstapel 300 bündig zueinander angeordnet. Figur 7 zeigt einen Ausschnitt einer solchen Beleuchtungseinrichtung.

Da die organischen lichtemittierenden Bauelemente keine äußeren Kontaktflächen aufweisen, wird die von der aktiven Schicht 32 des Schichtstapels 300 ausgekoppelte elektromagnetische Strahlung durch einen Großteil, bevorzugt im Wesentlichen durch die ganze sichtbare Fläche des Bauelements 10 ausgekoppelt. Die Beleuchtungseinrichtung weist daher eine möglichst einheitlich leuchtende Leuchtfläche auf, bei der die von den einzelnen Bauelementen 10 gebildeten Segmente der Leuchtfläche vom Betrachter nicht deutlich getrennt wahrgenommen werden.

## Patentansprüche

1. Organisches lichtemittierendes Bauelement, umfassend
- ein Substrat (100),
- eine auf dem Substrat angeordnete erste Elektrode (20),
- einen auf der ersten Elektrode (20) angeordneten Schichtstapel (300), der mindestens eine Schicht aufweist, die ein organisches Material enthält, wobei der Schichtstapel (300) dazu geeignet ist, elektromagnetische Strahlung zu erzeugen,
- eine auf dem Schichtstapel angeordnete zweite Elektrode (40),
- eine auf die zweite Elektrode (40) aufgebrachte isolierende Schicht (5), welche die zweite Elektrode (40) zumindest teilweise bedeckt,
- eine Empfängervorrichtung (6), die eine Spule umfasst und die geeignet ist, Energie aus einem elektromagnetischen Wechselfeld (14) zu entnehmen, zumindest teilweise in elektrische Energie umzuwandeln und dem Schichtstapel (300) die zur Strahlungsemission benötigte elektrische Energie zur Verfügung zu stellen, wobei der Schichtstapel (300) und die zweite Elektrode (40) sowie die isolierende Schicht (5) als auch die Empfängervorrichtung (6) zumindest teilweise übereinander angeordnet sind, sodass die Spule zumindest teilweise auf die isolierende Schicht (5) aufgebracht ist,
**dadurch gekennzeichnet, dass**
auf das Substrat (100) und auf den Schichtstapel (300) eine Verkapselung (80) aufgebracht ist, sodass die Außenfläche des Bauelements frei von elektrischen Kontaktflächen ist.

2. Organisches lichtemittierendes Bauelement gemäß Anspruch 1, bei dem die Spule eine rechteckige, eine sechseckige oder eine achteckige Spirale ist.

3. Organisches lichtemittierendes Bauelement gemäß Anspruch 1 oder 2, bei dem die isolierende Schicht (5) einen Randbereich der zweiten Elektrode (40) bedeckt und einen mittleren Bereich der zweiten Elektrode (40) freilässt.

4. Organisches lichtemittierendes Bauelement gemäß Anspruch 3, bei dem die Empfängervorrichtung (6) in dem mittleren Bereich mit der zweiten Elektrode (40) verbunden ist.

5. Organisches lichtemittierendes Bauelement gemäß Anspruch 1 oder 2, bei dem die isolierende Schicht (5) einen Randbereich der zweiten Elektrode (40) freilässt.

6. Organisches lichtemittierendes Bauelement gemäß Anspruch 5, bei dem die Empfängervorrichtung (6) in dem Randbereich mit der zweiten Elektrode (40) verbunden ist.

7. Organisches lichtemittierendes Bauelement gemäß einem der vorhergehenden Ansprüche, bei dem die Empfängervorrichtung (6) ein elektronisches Bauelement (17) umfasst und dazu geeignet ist, Wechselstrom gleichzurichten.

8. Organisches lichtemittierendes Bauelement gemäß Anspruch 7, bei dem das Bauelement (17) eine Diode umfasst.

9. Organisches lichtemittierendes Bauelement gemäß einem der vorhergehenden Ansprüche, bei dem die Verkapselung (80) das Substrat (100) in Draufsicht auf das Substrat vollständig überdeckt.

10. Organisches lichtemittierendes Bauelement gemäß Anspruch 9, bei dem die Verkapselung (80) und das Substrat (100) in Draufsicht auf das Substrat bündig zueinander angeordnet sind.

11. Organisches lichtemittierendes Bauelement gemäß einem der vorhergehenden Ansprüche, bei dem die Empfängervorrichtung (6) dazu vorgesehen ist, ein elektromagnetisches Wechselfeld einer Frequenz in einem Frequenzbereich zwischen einschließlich 30 kHz und 500 kHz oder zwischen einschließlich 10 MHz und 15 MHz zu detektieren.

12. Organisches lichtemittierendes Bauelement gemäß einem der vorhergehenden Ansprüche, das ein zur Speicherung von Information geeignetes datenspeicherndes Bauelement umfasst.

13. Vorrichtung, umfassend mindestens ein organisches lichtemittierendes Bauelement (10) gemäß einem der vorhergehenden Ansprüche und eine Steuereinheit (13), welche im Betrieb ein elektromagnetisches Wechselfeld (14) erzeugt, welches das Bauelement (10) mittels der Empfängervorrichtung (6) mit Energie versorgt.

14. Vorrichtung gemäß Anspruch 13, bei dem das organische lichtemittierende Bauelement (10) galvanisch von der Steuereinheit (13) getrennt ist.

15. Vorrichtung gemäß einem der Ansprüche 13 und 14, bei dem die Steuereinheit (13) das elektromagnetische Wechselfeld (14) aus einem Wechselstrom erzeugt.

16. Vorrichtung gemäß Anspruch 15, bei dem das von der Steuereinheit (13) erzeugte elektromagnetische Wechselfeld (14) induktiv in die Empfängervorrichtung (6) eingekoppelt ist.

17. Vorrichtung gemäß einem der Ansprüche 13 bis 16, die eine Halterung (15) umfasst, mit der das organische lichtemittierende Bauelement (10) mechanisch stabil verbunden ist.

18. Vorrichtung gemäß Anspruch 17, bei der die Halterung (15) die Steuereinheit (13) enthält.

19. Vorrichtung gemäß einem der Ansprüche 13 bis 18, bei dem die Steuereinheit (13) ein Hochfrequenzgerät darstellt, das im Betrieb ein Gebiet mit dem elektromagnetischen Wechselfeld (14) mit einer Frequenz zwischen einschließlich 30 kHz und 500 kHz oder zwischen einschließlich 10 MHz und 15 MHz bestrahlt, wobei das Hochfrequenzgerät dazu vorgesehen ist, Gegenstände mit dem elektromagnetischen Wechselfeld zu bestrahlen und das organische lichtemittierende Bauelement (10) in dem Gebiet angeordnet ist.

20. Beleuchtungseinrichtung, die mindestens eine Vorrichtung gemäß einem der Ansprüche 13 bis 19 umfasst.

21. Beleuchtungseinrichtung gemäß Anspruch 20, bei der eine Mehrzahl von organischen lichtemittierenden Bauelementen (10) in ihrer Haupterstreckungsebene zumindest in einer Richtung bündig zueinander angeordnet sind, sodass sie zusammen eine Leuchtfläche bilden.

22. Verfahren zur Herstellung eines organischen lichtemittierenden Bauelementes nach einem der Ansprüche 1 bis 12 mit den Schritten:
- Bereitstellen des Substrats (100);
- Herstellen des Schichtstapels (300), der die mindestens eine Schicht aufweist, die das organische Material enthält und der geeignet ist, die elektromagnetische Strahlung zu erzeugen, auf dem Substrat;
- Aufbringen der Verkapselung (80) auf das Substrat (100) und den Schichtstapel (300),
wobei die Verkapselung derart aufgebracht wird, dass die Außenfläche des Bauelements frei von elektrischen Kontaktflächen ist.

23. Verfahren nach Anspruch 22, bei dem eine Mehrzahl von organischen lichtemittierenden Bauelementen (10) hergestellt wird, wobei eine Mehrzahl von Schichtstapeln (300) auf einem Substrat (1) hergestellt wird und eine zusammenhängende Verkapselung (8) auf die Mehrzahl von Schichtstapeln (300) aufgebracht wird.

24. Verfahren nach Anspruch 23, bei dem die Bauelemente (10) mittels Schnitten (9) vereinzelt werden, die das Substrat (1) und die zusammenhängende Verkapselung (8) durchtrennen.

25. Verfahren nach Anspruch 23 oder 24, bei dem die zusammenhängende Verkapselung (8) Ausnehmungen (81) zur Aufnahme der Schichtstapel (300) aufweist.

26. Verfahren nach einem der Ansprüche 22 bis 25, bei dem das Substrat (100) und die Verkapselung (80) mittels einer strukturierten Verbindungsschicht (7) verbunden werden.

27. Verfahren nach Anspruch 26, bei dem die strukturierte Verbindungsschicht (7) thermisch und/oder optisch härtbar ist.

28. Verfahren nach Anspruch 27, bei dem die strukturierte Verbindungsschicht (7) durch Bestrahlen mit elektromagnetischer Strahlung ausgehärtet wird.

## Claims

1. Organic light-emitting component, comprising
- a substrate (100)
- a first electrode (20) arranged on the substrate,
- a layer stack (300) which is arranged on the first electrode (20) and which has at least one layer, which contains an organic material, wherein the layer stack (300) is suitable for producing electromagnetic radiation,
- a second electrode (40) arranged on the layer stack,
- an insulating layer (5), which is applied to the second electrode (40) and at least partially covers the second electrode (40),
- a receiver device (6) which comprises a coil and which is suitable for extracting energy from an electromagnetic alternating field (14), at least partially converting the extracted energy into electrical energy and providing the electrical energy required for radiation emission to the layer stack (300), wherein the layer stack (300) and the second electrode (40) as well as the insulating layer (5) and the receiver device (6) are arranged at least partially one above the other, so that the coil is at least partially applied to the insulating layer (5),
**characterized in that**
an encapsulation (80) is applied to the substrate (100) and to the layer stack (300), so that the outer surface of the component is free of electric contact surfaces.

2. Organic light-emitting element according to claim 1, in which the coil is a rectangular, hexagonal or an octagonal spiral.

3. Organic light-emitting element according to claim 1 or 2, in which the insulating layer (5) covers an edge region of the second electrode (40) and exposes a central region of the second electrode.

4. Organic light-emitting element according to claim 3, in which the receiver device (6) is connected to the second electrode (40) in the central region.

5. Organic light-emitting component according to claim 1 or 2, in which the insulating layer (5) exposes an edge region of the second electrode (40).

6. Organic light-emitting component according to claim 5, in which the receiving device (6) is connected to the second electrode (40) in the edge region.

7. Organic light-emitting component according to one of the preceding claims, in which the receiver device (6) comprises an electronic component (17) and is suitable for rectifying alternating current.

8. Organic light-emitting element according to claim 7, in which the component (17) comprises a diode.

9. Organic light-emitting component according to one of the preceding claims, in which the encapsulation (80) completely covers the substrate (100) in a plan view of the substrate.

10. Organic light-emitting component according to claim 9, in which the encapsulation (80) and the substrate (100) are arranged flush with each other in a plan view of the substrate.

11. Organic light-emitting component according to one of the preceding claims, in which the receiver device (6) is provided for detect an electromagnetic alternating field of a frequency in a frequency range between 30 kHz and 500 kHz inclusive or between 10 MHz and 15 MHz inclusive.

12. Organic light-emitting component according to one of the preceding claims, comprising a data-storage component suitable for storing information.

13. Device comprising at least one organic light-emitting component (10) according to one of the preceding claims and a control unit (13), which during operation generates an electromagnetic alternating field (14), which supplies the component (10) with energy by means of the receiver device (6) .

14. Device according to claim 13, in which the organic light-emitting component (10) is galvanically separated from the control unit (13).

15. Device according to one of claims 13 and 14, in which the control unit (13) generates the electromagnetic alternating field (14) from an alternating current.

16. Device according to claim 15, in which the electromagnetic alternating field (14) generated by the control unit (13) is inductively coupled into the receiver device (6).

17. Device according to one of claims 13 to 16, which comprises a holder (15) to which the organic light-emitting component (10) is mechanically stably connected.

18. Device according to claim 17, in which the holder (15) contains the control unit (13).

19. Device according to one of claims 13 to 18, in which the control unit (13) is a high-frequency device which, during operation, irradiates a region with the electromagnetic alternating field (14) having a frequency between 30 kHz and 500 kHz inclusive or between 10 MHz and 15 MHz inclusive, wherein the high-frequency device is provided to irradiate objects with the electromagnetic alternating field and the organic light-emitting component (10) is arranged in the region.

20. Illumination device comprising at least one device according to one of claims 13 to 19.

21. Illumination device according to claim 20, wherein a plurality of organic light-emitting components {10) are arranged flush with one other in their main plane of extension, at least in one direction, so that they together form a luminous surface.

22. Method for producing an organic light-emitting component according to one of claims 1 to 12 having the steps :
- providing substrate (100);
- producing the layer stack (300) on the substrate, wherein the layer stack has the at least one layer, which contains the organic material and which is suitable for producing the electromagnetic radiation;
- applying the encapsulation (80) to the substrate (100) and the layer stack (300), wherein the encapsulation is applied in such a way that the outer surface of the component is free of electrical contact surfaces.

23. Method according to claim 22, in which a plurality of organic light-emitting components (10) is produced, wherein a plurality of layer stacks (300) is produced on a substrate (1), and a continuous encapsulation (8) is applied to the plurality of layer stacks (300).

24. Method according to claim 23, in which the components (10) are singulated by means of cuts (9), which sever the substrate (1) and continuous encapsulation (8).

25. Method according to claim 23 or 24, in which the continuous encapsulation (8) has recesses (81) for receiving the layer stacks (300).

26. Method according to one of claims 22 to 25, in which the substrate (100) and the encapsulation (80) are connected by means of a structured connecting layer (7).

27. Method according to claim 26, in which the structured connecting layer is thermally and/or optically curable.

28. Method according to claim 27, in which the structured connecting layer (7) is cured by means of irradiation with electromagnetic radiation.

## Revendications

1. Composant luminescent organique, comprenant
- un substrat (100),
- une première électrode (20) disposée sur le substrat,
- un empilement de couches (300) disposé sur la première électrode (20) et comportant au moins une couche contenant un matériau organique, l'empilement de couches (300) étant apte à générer un rayonnement électromagnétique,
- une seconde électrode (40) disposée sur l'empilement de couches,
- une couche isolante (5) appliquée sur la seconde électrode (40) qui recouvre la seconde électrode (40) au moins partiellement,
- un dispositif récepteur (6) comportant une bobine et apte pour prélever de l'énergie sur un champ électromagnétique alternatif (14) en le convertissant au moins partiellement en énergie électrique et en alimentant à l'empilement de couches (300) l'énergie nécessaire à l'émission de rayonnement,
l'empilement de couches (300) et la seconde électrode (40) ainsi que la couche isolante (5) et le dispositif récepteur (6) étant au moins partiellement superposés l'un sur l'autre, de manière que la bobine est déposée au moins partiellement sur la couche isolante (5),
**caractérisé en ce qu'**un encapsulage (80) est appliqué sur le substrat (100) et sur l'empilement de couches (300), de manière que des surfaces extérieures du composant sont exemptes de surfaces de contact électrique.

2. Composant luminescent organique selon la revendication 1, dans lequel la bobine est une spirale rectangulaire, hexagonale ou octogonale.

3. Composant luminescent organique selon la revendication 1 ou 2, dans lequel la couche isolante (5) recouvre une zone périphérique de la seconde électrode (40), en laissant vierge une zone médiane de la seconde électrode (40) .

4. Composant luminescent organique selon la revendication 3, dans lequel le dispositif récepteur (6) est relié en zone médiane à la seconde électrode (40).

5. Composant luminescent organique selon la revendication 1 ou 2, dans lequel la couche isolante (5) laisse vierge une zone périphérique de la seconde électrode (40).

6. Composant luminescent organique selon la revendication 5, dans lequel le dispositif récepteur (6) est relié en zone périphérique à la seconde électrode (40).

7. Composant luminescent organique selon la revendication 5, dans lequel le dispositif récepteur (6) comporte un composant électronique (17) et est apte à redresser le courant alternatif.

8. Composant luminescent organique selon la revendication 7, dans lequel le composant (17) comprend une diode.

9. Composant luminescent organique selon l'une quelconque des revendications précédentes, dans lequel l'encapsulage (80) couvre entièrement le substrat (100) en vue de dessus sur le substrat.

10. Composant luminescent organique selon la revendication 9, dans lequel l'encapsulage (80) et le substrat (100) sont agencés à fleur l'un par rapport à l'autre en vue de dessus sur le substrat.

11. Composant luminescent organique selon l'une quelconque des revendications précédentes, dans lequel le dispositif récepteur (6) est destiné à détecter un champ électromagnétique alternatif d'une fréquence comprise dans une gamme de fréquences comprise entre 30 kHz et 500 kHz inclus ou entre 10 MHz et 15 MHz inclus.

12. Composant luminescent organique selon l'une quelconque des revendications précédentes comportant un composant de stockage de données apte pour stocker des informations.

13. Dispositif comprenant au moins un composant luminescent organique (10) selon l'une des revendications précédentes, ainsi qu'une unité de commande (13) générant, en service, un champ électromagnétique alternatif (14) alimentant le composant (10) en énergie moyennant le dispositif récepteur (6).

14. Dispositif selon la revendication 13, dans lequel le composant luminescent organique (10) est isolé galvaniquement de l'unité de commande (13).

15. Dispositif selon l'une des revendications 13 et 14, dans lequel l'unité de commande (13) génère le champ électromagnétique alternatif (14) à partir d'un courant alternatif.

16. Dispositif selon la revendication 15, dans lequel le champ électromagnétique alternatif (14) généré par l'unité de commande (13) est couplé par induction dans le dispositif récepteur (6).

17. Dispositif selon l'une quelconque des revendications 13 à 16 comportant un support (15) auquel le composant électroluminescent organique (10) est connecté de façon mécaniquement stable.

18. Dispositif selon la revendication 17, dans lequel le support (15) comporte l'unité de commande (13).

19. Dispositif selon l'une quelconque des revendications 13 à 18, dans lequel l'unité de commande (13) est un dispositif à haute fréquence, qui en service irradie une zone comportant le champ électromagnétique alternatif (14) à une fréquence comprise entre 30 kHz et 500 kHz inclus ou entre 10 MHz et 15 MHz inclus, le dispositif à haute fréquence étant destiné à irradier des objets par le champ électromagnétique alternatif, le composant luminescent organique (10) étant disposé dans ladite zone.

20. Dispositif d'éclairage comportant au moins un dispositif selon l'une des revendications 13 à 19.

21. Dispositif d'éclairage selon la revendication 20, dans lequel une pluralité de composants luminescents organiques (10) est disposée dans leur plan d'extension principal au moins dans une direction à fleur l'un par rapport à l'autre, de sorte qu'ensemble, ils constituent une surface lumineuse.

22. Procédé de réalisation d'un composant luminescent organique selon l'une quelconque des revendications 1 à 12, comportant les étapes suivantes :
- mise à disposition du substrat (100);
- réalisation sur le substrat de l'empilement de couches (300) comportant l'au moins une couche contenant le matériau organique et apte à générer le rayonnement électromagnétique;
- application de l'encapsulage (80) sur le substrat (100) et l'empilement de couches (300), l'encapsulage étant mise en place de manière à laisser exempte la surface extérieure du composant de surfaces de contact électrique.

23. Procédé selon la revendication 22, dans lequel on réalise une pluralité de composants luminescents organiques (10), une pluralité d'empilements de couches (300) étant réalisée sur un substrat (1) et un encapsulage cohérant (8) étant mis en place sur la pluralité d'empilements de couches (300).

24. Procédé selon la revendication 23, dans lequel les composants (10) sont séparés au moyen de découpes (9), l'ensemble du substrat (1) et de l'encapsulage (8) étant découpé de la sorte.

25. Procédé selon la revendication 23 ou 24, dans lequel l'encapsulage cohérent (8) présente des évidements (81) pour loger les empilements de couches (300).

26. Procédé selon l'une des revendications 22 à 25, dans lequel le substrat (100) et l'encapsulage (80) sont reliés à l'aide d'une couche de liaison (7) structurée.

27. Procédé selon la revendication 26, dans lequel la couche de liaison structurée (7) est durcissable optiquement et/ou thermiquement.

28. Procédé selon la revendication 27, dans lequel la couche de liaison structurée (7) est durcie à l'aide d'une irradiation par rayonnement électromagnétique.
